# EUROPEAN PATENT APPLICATION

(11) **EP 4 841 829 A1**
(43) Date of publication of application: **18.11.2026**
(21) Application number: 25772269.4
(22) Date of filing: 04.02.2025
(51) Int. Cl.: H01Q 13/18, H01Q 5/335, H01Q 1/24, H04M 1/02, H05K 1/02, H05K 1/11, H05K 1/14

(54) **ELECTRONIC DEVICE INCLUDING CAVITY-BACKED SLOT ANTENNA**

(30) Priority: 15.03.2024 KR 20240036792; 04.04.2024 KR 20240046295
(71) Applicant: Samsung Electronics Co., Ltd., Suwon-si, Gyeonggi-do 16677 (KR)
(72) Inventor: KIM, Dongyeon, Suwon-si Gyeonggi-do 16677 (KR)
(74) Representative: Gulde & Partner
(86) International application number: PCT/KR2025/099256
(87) International publication number: WO 2025/193023

(57) **Abstract**

A foldable electronic device according to one embodiment comprises: a foldable housing including a first housing part and a second housing part rotatably coupled to the first housing part; a printed circuit board; a wireless communication circuit; a bracket including a conductive cavity portion; and a flexible printed circuit board. The flexible printed circuit board covers the conductive cavity portion, and the conductive cavity portion and a portion of the flexible printed circuit board are configured to operate as a cavity-backed slot antenna.

## Description

### [Technical Field]

The present disclosure relates to an electronic device including a cavity-backed slot antenna.

### [Background Art]

An electronic device may include a plurality of antennas. As a band of radio frequency (RF) signals covered by the electronic device is expanded, the number of antennas mounted in the electronic device tends to increase. As a demand for a highly portable electronic device increases, the electronic device may include a deformable display. The deformable display may be foldably deformable. An electronic device including a deformable display may include housing parts rotatably coupled to each other.

The above-described information may be provided as related art for the purpose of helping the understanding of the present disclosure. No assertion or determination is raised as to whether any of the above-described content may be applied as prior art related to the present disclosure.

### [Disclosure]

### [Technical Solution]

A foldable electronic device is provided. The foldable electronic device may comprise a foldable housing. The foldable housing may include a first housing part and a second housing part rotatably coupled to the first housing part through a plurality of hinge modules including a first hinge module and a second hinge module. The foldable electronic device may comprise a printed circuit board (PCB) disposed in the first housing part. The foldable electronic device may comprise wireless communication circuitry on the PCB. The foldable electronic device may comprise a bracket disposed in the first housing part. The bracket may include a conductive cavity portion, and the conductive cavity portion may include a bottom wall portion and a side wall portion extending from the bottom wall portion. The foldable electronic device may comprise a flexible printed circuit board (FPCB) including a first portion and a second portion including a slot. The second portion may be disposed to cover the conductive cavity portion. The first portion may be configured to provide a path of radio frequency (RF) signals from the wireless communication circuitry to the second portion. The second portion of the FPCB and the conductive cavity portion may be configured to operate as a cavity-backed slot antenna. At least a portion of the cavity-backed slot antenna may be disposed between the first hinge module and the second hinge module.

An electronic device is provided. The electronic device may comprise a housing defining an exterior of the electronic device. The electronic device may comprise a PCB disposed in the housing. The electronic device may comprise wireless communication circuitry disposed on the PCB. The electronic device may comprise a bracket disposed in the housing. The bracket may include a conductive cavity portion, and the conductive cavity portion may include a bottom wall portion and a side wall portion extending from the bottom wall portion. The electronic device may comprise an FPCB including a first portion and a second portion including a slot. The second portion may be disposed to cover the conductive cavity portion. The first portion may be configured to provide a path of radio frequency (RF) signals from the wireless communication circuitry to the second portion. The second portion of the FPCB and the conductive cavity portion may be configured to operate as a cavity-backed slot antenna.

### [Description of the Drawings]

FIG. 1 is a block diagram of an electronic device in a network environment according to an embodiment.
FIG. 2A illustrates an example of an unfolded state of a foldable electronic device according to an example embodiment.
FIG. 2B illustrates an example of a folded state of a foldable electronic device according to an example embodiment.
FIG. 2C is an exploded view of a foldable electronic device according to an example embodiment.
FIG. 3 is a block diagram of an electronic device according to an example embodiment.
FIG. 4A illustrates a foldable electronic device according to an example embodiment, with a flexible display omitted.
FIG. 4B illustrates a foldable electronic device according to an example embodiment, with a rear cover and a sub-display omitted.
FIG. 5A is a cross-sectional view of an electronic device according to an example embodiment, cut along line A-A' of FIG. 4A.
FIG. 5B is a cross-sectional view of an electronic device according to an example embodiment, cut along line B-B' of FIG. 4A.
FIG. 5C is a cross-sectional view of an electronic device according to an example embodiment, cut along line C-C' of FIG. 4A.
FIG. 6 illustrates a first bracket of a foldable electronic device according to an example embodiment.
FIG. 7 is a cross-sectional view of an electronic device according to an example embodiment, cut along line D-D' of FIG. 4B.
FIG. 8A illustrates a top view of a flexible printed circuit board according to an example embodiment.
FIG. 8B illustrates a bottom view of a flexible printed circuit board according to an example embodiment.
FIG. 8C is a cross-sectional view of an example flexible printed circuit board.
FIG. 9A illustrates a portion of a flexible printed circuit board according to an example embodiment.
FIG. 9B is a perspective view of a portion of a flexible printed circuit board according to an example embodiment.
FIG. 9C is a cross-sectional view of a flexible printed circuit board according to an example embodiment, cut along line E-E' of FIG. 9B.
FIG. 10A, FIG. 10B, and FIG. 10C are example cross-sectional views of a conductive cavity portion of a foldable electronic device according to an example embodiment.
FIG. 11A illustrates a slot of a flexible printed circuit board according to an example embodiment.
FIG. 11B and FIG. 11C illustrate radiation patterns formed by a cavity-backed slot antenna of an electronic device according to an example embodiment.
FIG. 12 is a graph illustrating a reflection coefficient of a cavity-backed slot antenna based on a length of a conductive stub of a foldable electronic device according to an example embodiment.
FIG. 13 is a graph illustrating a reflection coefficient of a cavity-backed slot antenna based on a position of a conductive stub of a foldable electronic device with respect to a slot according to an example embodiment.
FIG. 14A illustrates an electronic device according to an example embodiment.
FIG. 14B is an exploded perspective view of the electronic device illustrated in FIG. 14A.

### [Mode for Invention]

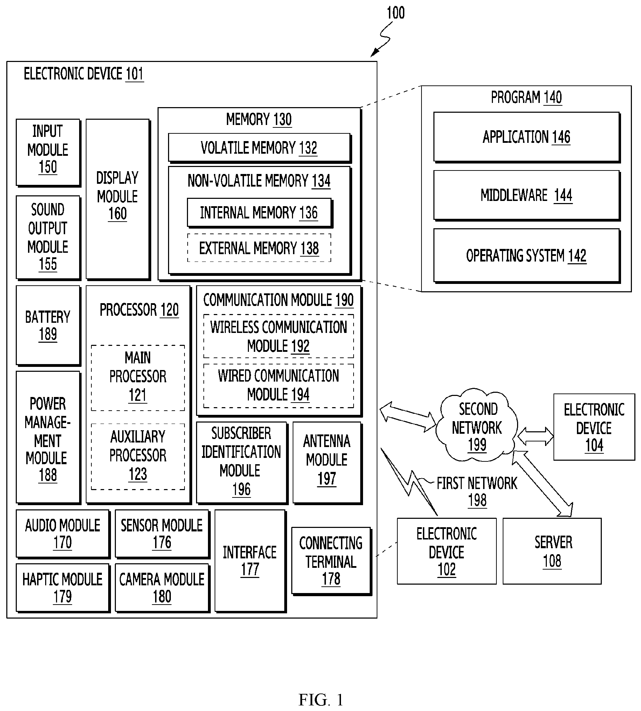

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

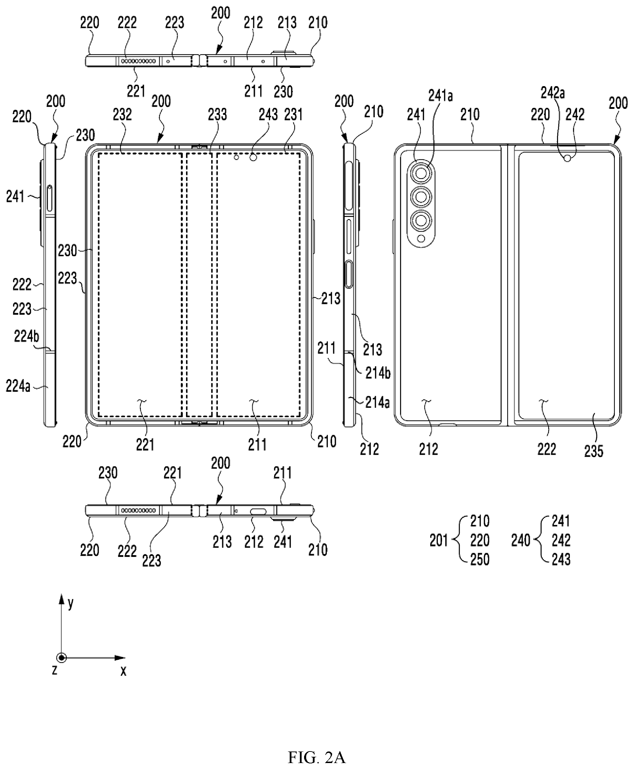

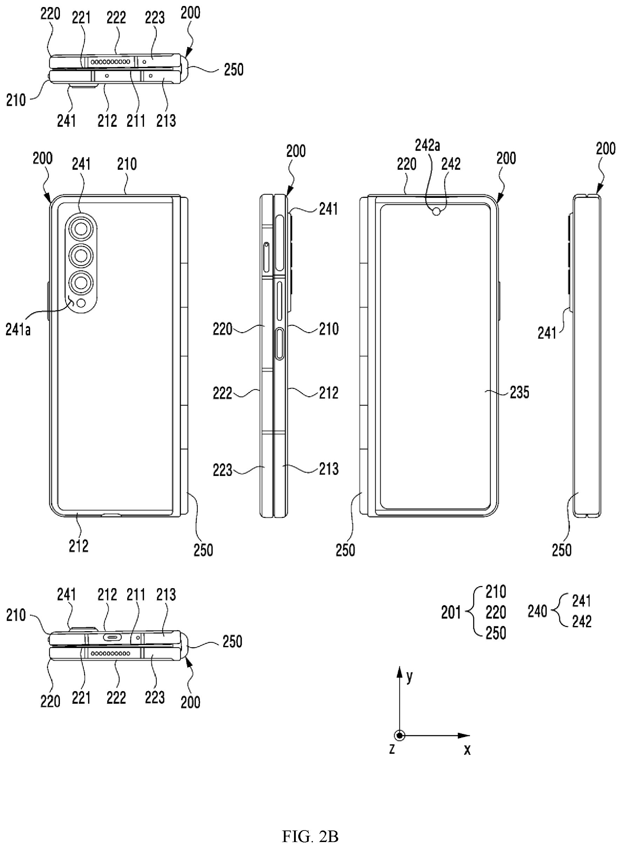

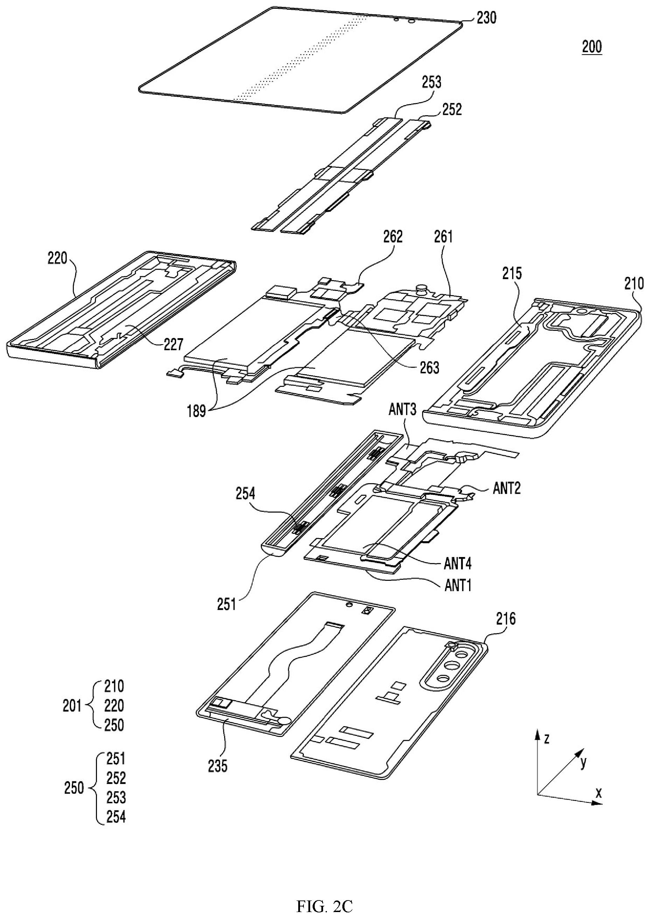

FIG. 2A illustrates an example of an unfolded state of a foldable electronic device according to an example embodiment. FIG. 2B illustrates an example of a folded state of a foldable electronic device according to an example embodiment. FIG. 2C is an exploded view of a foldable electronic device according to an example embodiment.

Referring to FIG. 2A, FIG. 2B, and FIG. 2C, the electronic device 101 of FIG. 1 described above may include a foldable electronic device 200. The foldable electronic device 200 may include a foldable housing 201, a flexible display 230 (e.g., the display module 160 of FIG. 1), or one or more cameras 240.

According to an example embodiment, the foldable housing 201 may define an exterior surface of the foldable electronic device 200. For example, the foldable housing 201, which is a physical exterior of the foldable electronic device 200 exposed to the outside, may accommodate components disposed inside the foldable electronic device 200. At least a portion of components for implementing a function of the foldable electronic device 200 may be disposed in the foldable housing 201. According to an example embodiment, the foldable housing 201 may include a first housing part 210, a second housing part 220, and a hinge assembly 250.

According to an example embodiment, the first housing part 210 may include a first surface 211, a second surface 212 opposite to the first surface 211, and a first side exterior surface 213 at least partially enclosing a periphery of the first surface 211 and a periphery of the second surface 212. For example, the first surface 211 may be referred to as a front exterior surface of the first housing part 210, and the second surface 212 may be referred to as a rear exterior surface of the first housing part 210. The first side exterior surface 213 may be connected to a periphery of the first surface 211 and a periphery of the second surface 212. The first surface 211, the second surface 212, and the first side exterior surface 213 may form an internal space of the first housing part 210. For example, at least one component may be disposed in a space enclosed by the first surface 211, the second surface 212, and the first side exterior surface 213.

For example, the second housing part 220 may include a third surface 221, a fourth surface 222 opposite to the third surface 221, and a second side exterior surface 223 at least partially enclosing a periphery of the third surface 221 and a periphery of the fourth surface 222. For example, the third surface 221 may be referred to as a front exterior surface of the second housing part 220, and the fourth surface 222 may be referred to as a rear exterior surface of the second housing part 220. The second side exterior surface 223 may be connected to a periphery of the third surface 221 and a periphery of the fourth surface 222. The third surface 221, the fourth surface 222, and the second side exterior surface 223 may form an internal space of the second housing part 220. For example, at least one component may be disposed in a space enclosed by the third surface 221, the fourth surface 222, and the second side exterior surface 223.

According to an example embodiment, the flexible display 230 may be configured to display visual information. For example, the flexible display 230 may include a display area including a plurality of pixels. For example, an active area may be referred to as an active area displaying visual information. For example, the flexible display 230 may define at least a portion of a front exterior surface of the foldable housing 201. For example, the flexible display 230 may at least partially form the first surface 211 and the third surface 221.

According to an example embodiment, the flexible display 230 may include a first display area 231, a second display area 232, and a third display area 233 disposed between the first display area 231 and the second display area 232. The foldable electronic device 200 may further include a sub-display 235 distinct from the flexible display 230. The sub-display 235 may at least partially form the fourth surface 222 of the second housing part 220. The sub-display 235 may be referred to as a cover display.

According to an example embodiment, the one or more cameras 240 may be configured to obtain an image based on receiving light from a subject outside the foldable electronic device 200. For example, the one or more cameras 240 may include first cameras 241, a second camera 242, and/or a third camera 243. For example, the first cameras 241 may be disposed in the first housing part 210. For example, the first housing part 210 may include at least one opening 241a overlapping the first cameras 241 when the foldable electronic device 200 is viewed from above. The first cameras 241 may obtain an image based on receiving light from outside the foldable electronic device 200 through the at least one opening 241a.

According to an example embodiment, the second camera 242 may be disposed in the second housing part 220. The second housing part 220 may include at least one opening 242a overlapping the second camera 242 when the foldable electronic device 200 is viewed from above. The second camera 242 may obtain an image based on receiving light from outside the foldable electronic device 200 through the at least one opening 242a.

According to an example embodiment, the third camera 243 may be disposed in the first housing part 210. For example, the first display area 231 of the flexible display 230 may include at least one opening overlapping the third camera 243 when the flexible display 230 is viewed from above. The third camera 243 may obtain an image based on receiving light from outside the flexible display 230 through the at least one opening.

According to an example embodiment, the second camera 242 and the third camera 243 may be disposed below the flexible display 230 or the sub-display 235 (e.g., in a -z direction). For example, the second camera 242 and/or the third camera 243 may include an under display camera (UDC) and/or a punch hole camera.

According to an example embodiment, the first housing part 210 and the second housing part 220 may be rotatably coupled. For example, the second housing part 220 may be rotatably coupled to the first housing part 210 through the hinge assembly 250.

According to an example embodiment, the hinge assembly 250 may rotatably connect the first housing part 210 and the second housing part 220. The hinge assembly 250 may be disposed between the first housing part 210 and the second housing part 220 of the foldable electronic device 200 so that the foldable electronic device 200 may be folded. The hinge assembly 250 may allow the foldable electronic device 200 to be changed from an unfolded state to a folded state. The hinge assembly 250 may allow the foldable electronic device 200 to be changed from the folded state to the unfolded state. For example, the hinge assembly 250 may maintain the foldable electronic device 200 in an intermediate state between the unfolded state and the folded state.

According to an example embodiment, the unfolded state may be referred to as a state in which a first direction in which a first display area 230a faces and a second direction in which a second display area 230b faces are substantially the same. The folded state may be referred to as a state in which the first direction is substantially opposite to the second direction. When the foldable electronic device 200 is in the folded state, the first housing part 210 and the second housing part 220 may be stacked or overlap.

According to an example embodiment, when the foldable electronic device 200 is in the folded state and the intermediate state, the first direction and the second direction may be different from each other. For example, when the foldable electronic device 200 is in the folded state, the first direction and the second direction may be opposite to each other. For example, when the foldable electronic device 200 is in the intermediate state, the first direction may form an angle (e.g., an angle greater than 0 degrees and less than 180 degrees) with respect to the second direction.

For example, the foldable electronic device 200 may include at least one conductive portion 214a and 224a and at least one non-conductive portion 214bb and 224b included in the first side exterior surface 213 and/or a third side exterior surface 223. For example, the at least one conductive portion 214a and 224a may be separated from another conductive portion in the first side exterior surface 213 and/or the third side exterior surface 223 by contacting the at least one non-conductive portion 214b and 224b. In an embodiment, the at least one conductive portion 214a and 224a may operate as an antenna radiator to be used for communication with an external electronic device.

Referring to FIG. 2C, the hinge assembly 250 may include a hinge cover 251, a first hinge plate 252, a second hinge plate 253, and a plurality of hinge modules 254. The hinge cover 251 may at least partially enclose components of the hinge assembly 250 and form an exterior surface of the hinge assembly 250. When the foldable electronic device 200 is in the folded state, the hinge cover 251 may be at least partially exposed to the outside of the foldable electronic device 200 through a space between the first housing part 210 and the second housing part 220. When the foldable electronic device 200 is in the unfolded state, the hinge cover 251 may be covered by the first housing part 210 and the second housing part 220 and may not be exposed to the outside of the foldable electronic device 200.

According to an example embodiment, the first hinge plate 252 and the second hinge plate 253 may rotatably connect the first housing part 210 and the second housing part 220 by being operatively coupled to the first housing part 210 and the second housing part 220, respectively. For example, the first hinge plate 252 may be operatively coupled to a first bracket 215 of the first housing part 210, and the second hinge plate 253 may be operatively coupled to a second bracket 227 of the second housing part 220. As the first hinge plate 252 and the second hinge plate 253 are operatively coupled to the first bracket 215 and the second bracket 227, respectively, the first housing part 210 and the second housing part 220 may be rotatable according to rotation of the first hinge plate 252 and the second hinge plate 253.

According to an example embodiment, the plurality of hinge modules 254 may rotate the first hinge plate 252 and the second hinge plate 253. For example, the plurality of hinge modules 254 may include gears rotatable by being engaged with each other. The first hinge plate 252 and the second hinge plate 253 may be rotated based on a rotational operation of the gears of the plurality of hinge modules 254.

According to an example embodiment, the first housing part 210 may include the first bracket 215 and a rear cover 216. The first bracket 215 may be disposed inside the first housing part 210 and may support at least one component disposed in the first housing part 210. The rear cover 216 may at least partially form the second surface 222 of the first housing part 210. For example, the second housing part 220 may include the second bracket 227. The second bracket 227 may be disposed inside the second housing part 220 and may support at least one component disposed in the second housing part 220. For example, the sub-display 235 may be disposed below the second bracket 227 (e.g., in the -z direction).

The foldable electronic device 200 according to an example embodiment may include a plurality of electronic components for implementing various functions in addition to the one or more cameras 240 described above. For example, the foldable electronic device 200 may include a first printed circuit board (PCB) 261, a second printed circuit board (PCB) 262, a flexible printed circuit board (FPCB) 263, and/or a battery 189. The electronic components described above are merely examples and are not limited thereto.

For example, the first PCB 261 and the second PCB 262 may provide an electrical connection of components in the foldable electronic device 200, respectively. For example, the first PCB 261 may be disposed in the first housing part 210, and the second PCB 262 may be disposed in the second housing part 220. The first PCB 261 may provide electrical connection between electronic components disposed in the first housing part 210. The second PCB 262 may provide electrical connection between electronic components disposed in the second housing part 220. The FPCB 263 may electrically connect the first PCB 261 and the second PCB 262. For example, the FPCB 263 may extend from the first PCB 261 across the hinge assembly 250 to the second PCB 262. For example, the FPCB 263 may at least partially overlap the hinge assembly 250.

According to an example embodiment, the battery 189, which is a device for supplying power to at least one component of the foldable electronic device 200, may include, for example, a non-rechargeable primary battery and/or a rechargeable secondary battery.

According to an example embodiment, the foldable electronic device 200 may include a plurality of antennas ANT1, ANT2, ANT3, or ANT4 to be used for communication with an external electronic device. For example, the foldable electronic device 200 may include a main antenna ANT1, a sub-antenna ANT2, an ultra-wide band (UWB) antenna ANT3, and/or an antenna ANT4 for near-field wireless communication. However, it is not limited thereto.

Hereinafter, one or more components to be described below with reference to the drawings may be implemented together with the components of the foldable electronic device 200 described with reference to FIG. 2A, FIG. 2B, and FIG. 2C. The same reference numerals are assigned to the same components as the components described above, and redundant descriptions may be omitted.

In the present disclosure, relative terms such as "above" and "below" may be used to describe relative positions between components. For example, when the foldable electronic device 200 illustrated in the drawings is turned upside down, "above" and "below" may be interchanged.

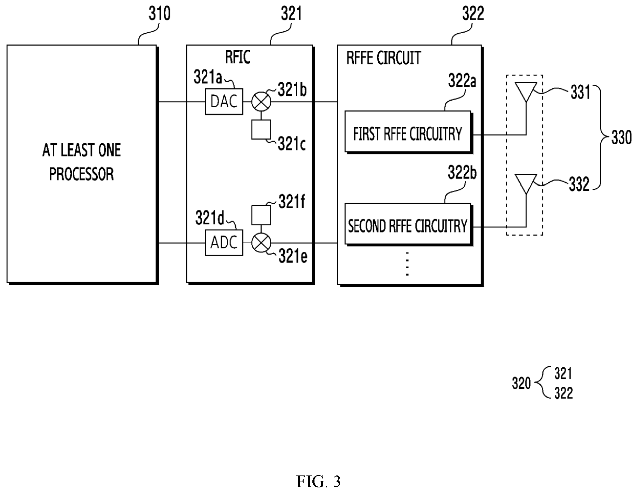

FIG. 3 is a block diagram of an electronic device according to an example embodiment.

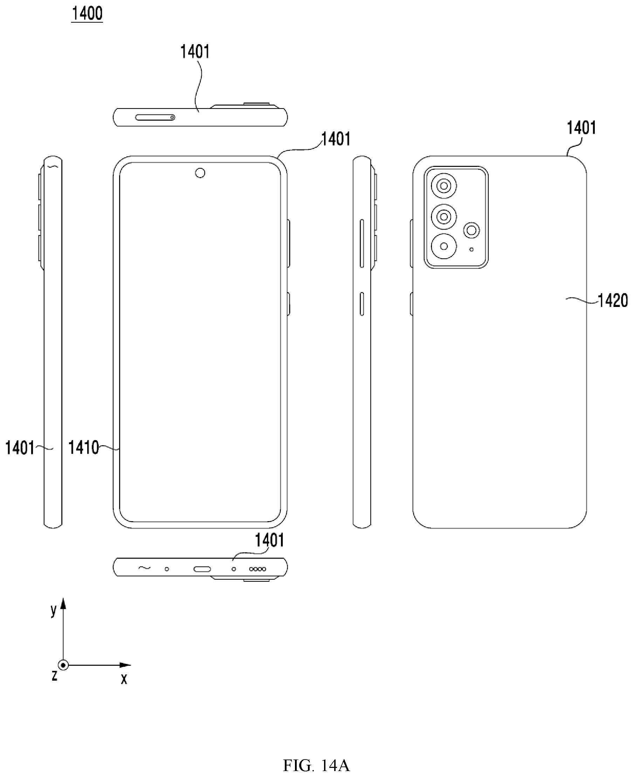

Referring to FIG. 3, an electronic device (e.g., the electronic device 101 of FIG. 1, the foldable electronic device 200 of FIG. 2A, or an electronic device 1400 of FIG. 14A) according to an example embodiment may include at least one processor 310, wireless communication circuitry 320 (e.g., the wireless communication module 192 of FIG. 1), and/or at least one antenna 330. For example, the wireless communication circuitry 320 may include a radio frequency integrated circuit (RFIC) 321 and an RF front end (RFFE) circuitry 322.

According to an example embodiment, the at least one processor 310 may include at least one of an application processor (AP) or a communication processor (CP). For example, the at least one processor 310 may generate a baseband signal. The at least one processor 310 may control the RFIC 321 to process the generated baseband signal. The at least one processor 310 may control the RFIC 321 so that a transmission signal is transmitted through the at least one antenna 330. The at least one processor 310 may control the RFIC 321 so that the transmission signal is transmitted in a frequency band capable of communicating with an external electronic device.

Any function or operation described in the specification may be processed by the at least one processor 310. According to an embodiment, the at least one processor 310 may include processing circuitry. The at least one processor 310 may include an application processor (AP, e.g., a central processing unit (CPU)) and/or a communication processor (CP, e.g., a modem), but is not limited thereto. The at least one processor 310 may include a graphics processing unit (GPU), a neural processing unit (NPU) (e.g., an artificial intelligence (AI) chip), a wireless-fidelity (Wi-Fi) chip, a Bluetooth^{®} chip, a global positioning system (GPS) chip, a near field communication (NFC) chip, connectivity chips, a sensor controller, a touch controller, a fingerprint sensor controller, a display drive integrated circuit (DDI), an audio CODEC chip, a universal serial bus (USB) controller, a camera controller, an image processing IC, a microprocessor unit (MPU), a system on chip (SoC), integrated circuitry (IC), or circuitry similar thereto.

According to an example embodiment, the RFIC 321 may be implemented as a single chip or as a portion of a single package. The RFIC 321 may include a digital to analog converter (DAC) 321a for converting a digital signal into an analog signal. The RFIC 321 may include a mixer 321b and an oscillator (e.g., a local oscillator (LO)) 321c for up-conversion. The RFIC 321 may convert a baseband signal generated by the at least one processor 310 into an RF signal. The RFIC 321 may include an analog to digital converter (ADC) 321d for converting an analog signal into a digital signal. The RFIC 321 may include a mixer 321e and an oscillator 321f for downconversion. The RFIC 321 may convert an RF signal received from the at least one antenna 330 into a baseband signal so as to be processed by the at least one processor 310.

According to an example embodiment, the RFFE circuitry 322 may include a plurality of components electrically connected between the RFIC 321 and each of the antennas. For example, the RFFE circuitry 322 may include components such as a coupler, a power amplifier (PA), a low noise amplifier (LNA), a switch circuit, and/or a duplexer, but is not limited thereto.

According to an example embodiment, the wireless communication circuitry 320 may be configured to communicate with an external electronic device using a signal on a designated frequency band. For example, the at least one antenna 330 may be used to transmit and/or receive a signal on the designated frequency band. For example, the at least one antenna 330 may include a feeding point to which a feeding signal provided from the RFIC 321 is provided, and a ground point electrically connected to a ground. The at least one antenna 330 may include an antenna radiator, which is a physical component for radiating or receiving electromagnetic waves. A shape and characteristics of the antenna (e.g., frequency characteristics of the antenna) may be determined by the antenna radiator.

An electronic device (e.g., the electronic device 101 of FIG. 1, the foldable electronic device 200 of FIG. 2A, and/or the electronic device 1400 of FIG. 14A) according to an example embodiment may use the at least one antenna 330. For example, the at least one antenna 330 may have various operating frequencies. The at least one antenna 330 may transmit and/or receive a signal corresponding to an operating frequency. For example, the at least one antenna 330 may include a first antenna 331 or a second antenna 332. The electronic device 101, 200, or 1400 may perform a multiple-input and multiple-output (MIMO) operation using the first antenna 331 and the second antenna 332. For example, the first antenna 331 and a first RFFE circuitry 322a electrically connected to the first antenna 331 may be used to transmit and/or receive a first signal on a first frequency band, and the second antenna 332 and a second RFFE circuitry 322b electrically connected to the second antenna 332 may be used to transmit and/or receive a second signal on a second frequency band.

According to an example embodiment, as a frequency band covered by the electronic device 101, 200, or 1400 increases, the number of the at least one antenna 330 included in the electronic device 101, 200, or 1400 may increase. For example, as described with reference to FIG. 2A, FIG. 2B, and FIG. 2C, the foldable electronic device 200 may include a first housing part (e.g., the first housing part 210 of FIG. 2A) and a second housing part (e.g., the second housing part 220 of FIG. 2A) rotatably coupled to the first housing part 210. The foldable electronic device 200 may include a plurality of hinge modules (e.g., the plurality of hinge modules 254 of FIG. 2A) rotatably connecting the first housing part 210 and the second housing part 220. In a case of the foldable electronic device 200, since space for the plurality of hinge modules 254 is required, space for disposing the at least one antenna 330 may be insufficient. Since the plurality of hinge modules 254 are disposed between the first housing part 210 and the second housing part 220 in the foldable electronic device 200, a portion of a periphery of the first housing part 210 and a portion of a periphery of the second housing part 220, which are adjacent to the plurality of hinge modules 254, may be difficult to be used as an antenna radiator. In order for a user to easily carry the foldable electronic device 200, each of a size of the first housing part 210 and a size of the second housing part 220 may be relatively small. Since the first housing part 210 and the second housing part 220 having a relatively small size have limited space for mounting electronic components, space for disposing the at least one antenna 330 may be insufficient.

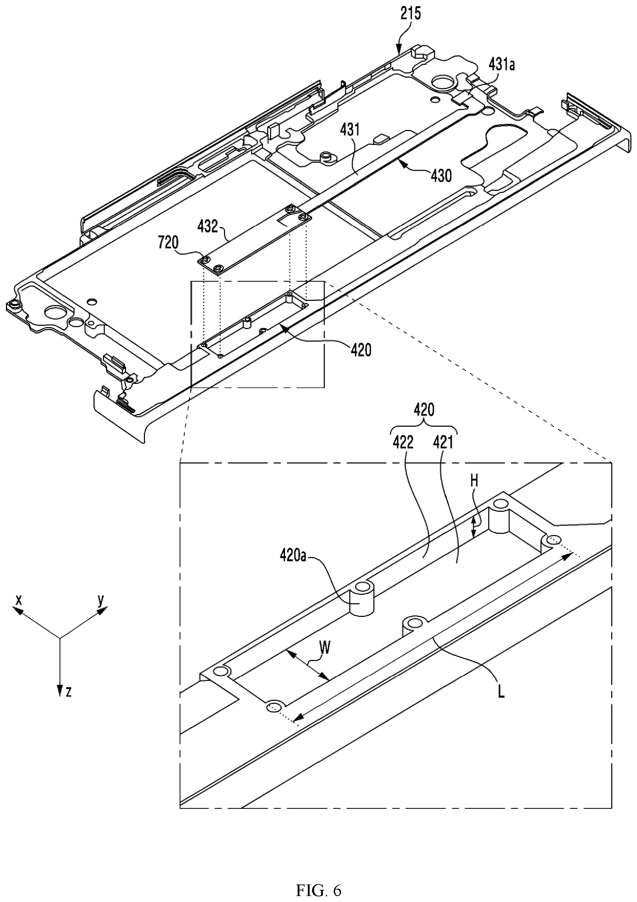

The foldable electronic device 200 according to an example embodiment may implement a cavity-backed slot antenna using a portion of a first bracket (e.g., a first bracket 215 of FIG. 6) in the first housing part 210. For example, a conductive cavity portion (e.g., a conductive cavity portion 420 of FIG. 6) may be formed in a partial area on the first bracket 215 where no electronic component is disposed. The conductive cavity portion 420 may be formed, for example, by processing a portion of the first bracket 215. The foldable electronic device 200 may include a flexible printed circuit board (FPCB) (e.g., a flexible printed circuit board 430 of FIG. 6) for providing a cavity-backed slot antenna. A portion (e.g., a first portion 431 of FIG. 6) of the FPCB 430 may be configured to provide a path of RF signals from the wireless communication circuitry 320. Another portion (e.g., a second portion 432 of FIG. 6) of the FPCB 430 may be configured to operate as an antenna radiator for radiating RF signals together with the conductive cavity portion 420. Hereinafter, a structure for providing a cavity-backed slot cavity antenna and a position of the backed-slot cavity antenna are described.

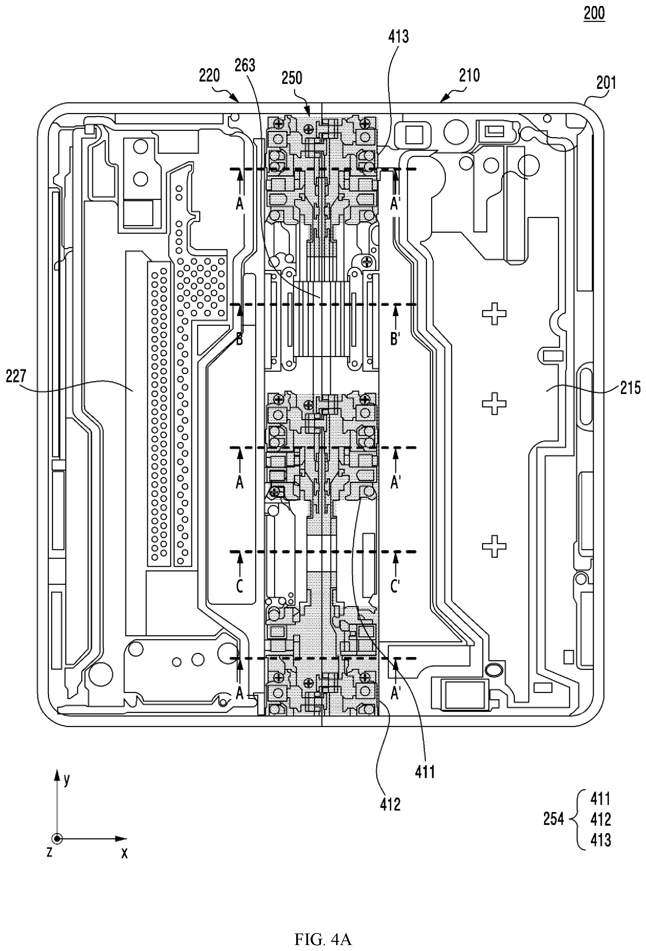

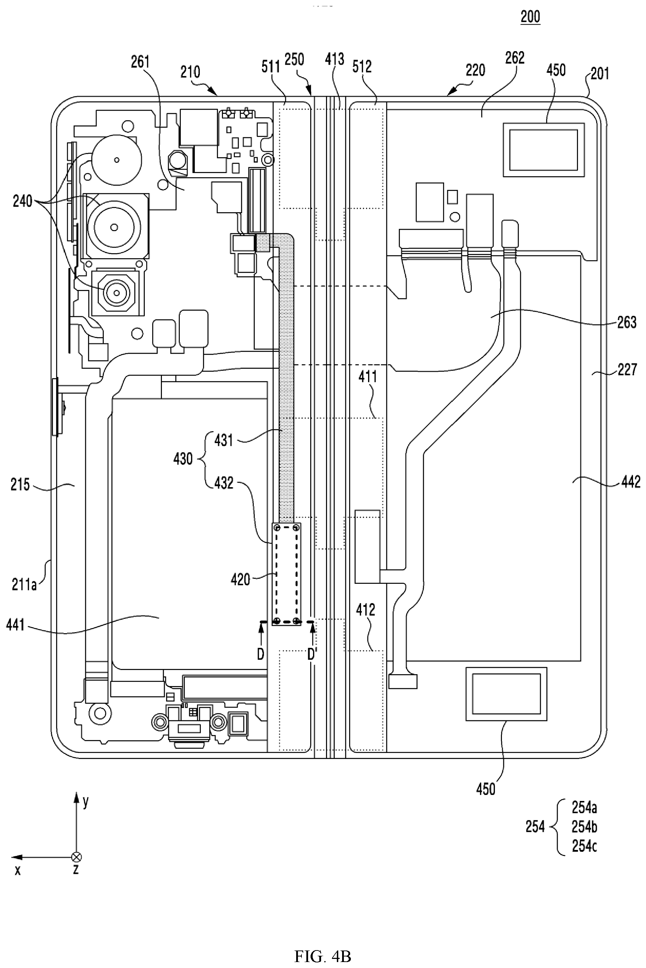

FIG. 4A illustrates a foldable electronic device according to an example embodiment, with a flexible display omitted. FIG. 4B illustrates a foldable electronic device according to an example embodiment, with a rear cover and a sub-display omitted.

Referring to FIG. 4A, a foldable electronic device 200 may include a hinge assembly 250 rotatably connecting a first housing part 210 and a second housing part 220. The hinge assembly 250 may be disposed substantially between the first housing part 210 and the second housing part 220.

According to an example embodiment, the first housing part 210 may include a first bracket 215. The first bracket 215 may be disposed in the first housing part 210 and may support an electronic component in the first housing part 210. For example, a first printed circuit board (PCB) (e.g., a first printed circuit board 261 of FIG. 4B), one or more cameras (e.g., one or more cameras 240 of FIG. 4B), and/or a first battery (e.g., a first battery 441 of FIG. 4B) disposed in the first housing part 210 may be supported by the first bracket 215. The first bracket 215 may support a partial area (e.g., the first display area 231 of FIG. 2A) of a flexible display (e.g., the flexible display 230 of FIG. 2A).

According to an example embodiment, the second housing part 220 may include a second bracket 227. The second bracket 227 may be disposed in the second housing part 220 and may support an electronic component in the second housing part 220. For example, a second printed circuit board (PCB) (e.g., a second printed circuit board 262 of FIG. 4B), one or more speaker modules (e.g., one or more speaker modules 450 of FIG. 4B), and a second battery (e.g., a second battery 442 of FIG. 4B) disposed in the second housing part 220 may be supported by the second bracket 227. The second bracket 227 may support another partial area (e.g., the second display area 232 of FIG. 2A) of the flexible display 230. The first bracket 215 and the second bracket 227 may be referred to as a support structure, a support member, or a support plate in terms of supporting components.

According to an example embodiment, the hinge assembly 250 may include a plurality of hinge modules 254. Each of the plurality of hinge modules 254 may include a first rotating plate (e.g., a first rotating plate 511 of FIG. 4B) coupled to the first bracket 215, a second rotating plate (e.g., a second rotating plate 512 of FIG. 4B) coupled to the second bracket 227, and gears and/or spiral linking components for a rotational operation of the first rotating plate 511 and a rotational operation of the second rotating plate 512.

According to an example embodiment, the plurality of hinge modules 254 may include a first hinge module 411, a second hinge module 412, and/or a third hinge module 413. The first hinge module 411, the second hinge module 412, and the third hinge module 413 may be spaced apart from each other. For example, the first hinge module 411 may be positioned between the second hinge module 412 and the third hinge module 413. The second hinge module 412 may be adjacent to a lower (e.g., in a -y direction) periphery portion of the foldable housing 201. The third hinge module 413 may be adjacent to an upper (e.g., in a +y direction) periphery portion of the foldable housing 201. For example, the first hinge module 411 between the second hinge module 412 and the third hinge module 413 may be positioned closer to the second hinge module 412 than to the third hinge module 413. However, the number and positions of the plurality of hinge modules 254 are not limited thereto. The number of the plurality of hinge modules 254 may be two, or four or more.

According to an example embodiment, the foldable electronic device 200 may include the first PCB 261 and the second PCB 262. The first PCB 261 and the second PCB 262 may each provide electrical connection between electronic components of the foldable electronic device 200. The first PCB 261 may be disposed in the first housing part 210, and the second PCB 262 may be disposed in the second housing part 220. The first PCB 261 and the second PCB 262 may include a plurality of conductive layers and a plurality of non-conductive layers alternately laminated with the plurality of conductive layers. The first PCB 261 and the second PCB 262 may provide electrical connection between electronic components using wirings and conductive vias formed in the conductive layers. For example, at least one processor (e.g., the at least one processor 310 of FIG. 3) and wireless communication circuitry (e.g., the wireless communication circuitry 320 of FIG. 3) may be disposed on the first PCB 261.

The foldable electronic device 200 according to an example embodiment may include a flexible printed circuit board (FPCB) 263 for electrically connecting the first PCB 261 and the second PCB 262. The FPCB 263 may electrically connect the first PCB 261 and the second PCB 262. For example, the FPCB 263 may extend from the first PCB 261 across the hinge assembly 250 to the second PCB 262. For example, the FPCB 263 may be disposed to cross a space between the first hinge module 411 and the third hinge module 413. The FPCB 263 may be at least partially deformed according to a folded state or an unfolded state of the foldable electronic device 200. The FPCB 263 may have flexibility so that it may be at least partially deformed.

Referring to FIG. 4B, the first PCB 261 and the second PCB 262 may be disposed close to an upper (e.g., in the +y direction) periphery portion of the foldable housing 201. A portion of the FPCB 263 extending from the first PCB 261 to the second PCB 262 may pass between the first hinge module 411 and the third hinge module 413, which are relatively positioned at an upper portion. For example, the FPCB 263 may extend from the first PCB 261 in the first housing part 210, across a space between the first hinge module (e.g., the first hinge module 411 of FIG. 4A) and the third hinge module (e.g., the third hinge module 413 of FIG. 4A), to the second PCB 262 in the second housing part 220.

The foldable electronic device 200 according to an example embodiment may include a flexible printed circuit board (FPCB) 430. The FPCB 430 may extend from the first PCB 261 to a conductive cavity portion 420 of the first bracket 215. According to an example embodiment, at least a portion of the FPCB 430 may be configured to operate as a cavity-backed slot antenna together with the conductive cavity portion 420. The foldable electronic device 200 may use the cavity-backed slot antenna for communication with an external electronic device. The cavity-backed slot antenna may be referred to as one of the at least one antenna 330 of FIG. 3.

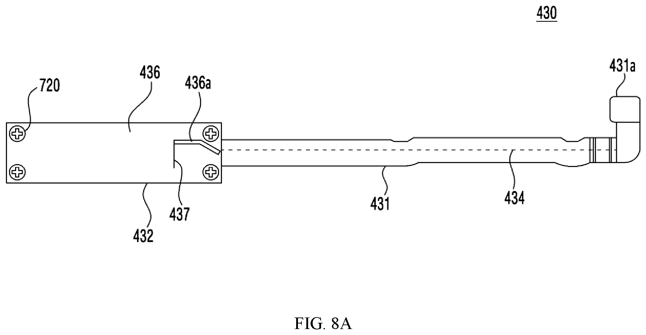

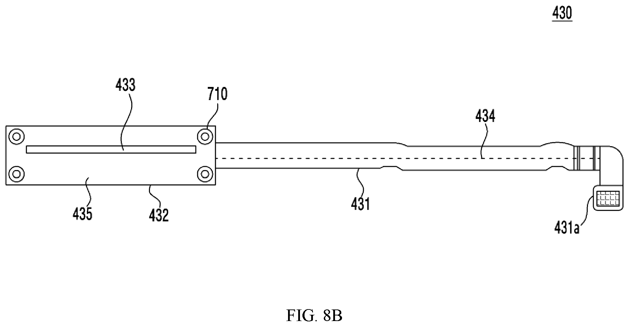

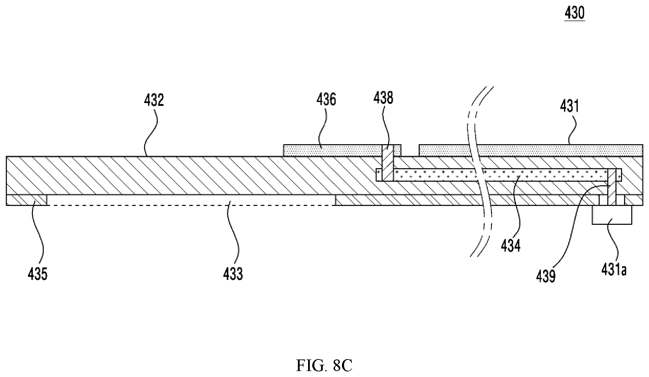

According to an example embodiment, the FPCB 430 may include a first portion 431 and a second portion 432. According to an example embodiment, the first portion 431 may be configured to provide a path of RF signals provided from the wireless communication circuitry 320 disposed on a PCB. For example, the first portion 431 may be connected to the first PCB 261 and may include a transmission line (e.g., a first layer 434 of FIG. 8C) used as a path of RF signals provided from the wireless communication circuitry 320. The RF signals provided from the wireless communication circuitry 320 may be provided to the first portion 431 through the PCB. According to an example embodiment, the second portion 432 may be disposed to cover the conductive cavity portion 420. For example, the conductive cavity portion 420 may be covered by the second portion 432. The second portion 432 may include a slot (e.g., a slot 433 of FIG. 8C) to which the RF signals provided from the first portion 431 are fed. The RF signals may be radiated to the outside of the foldable electronic device 200 through the slot 433. A detailed structure and components of the FPCB 430 will be described below with reference to FIG. 8A, FIG. 8B, and FIG. 8C.

According to an example embodiment, at least a portion of the conductive cavity portion 420 may be disposed between the first hinge module 411 and the second hinge module 412. For example, at least a portion of the conductive cavity portion 420 may be formed in an area of the first bracket 215 corresponding to a space between the first hinge module 411 and the second hinge module 412.

According to an example embodiment, the conductive cavity portion 420 may be adjacent to the plurality of hinge modules 254. The conductive cavity portion 420 being adjacent to the plurality of hinge modules 254 may be referred to as the conductive cavity portion 420 being positioned closer to the plurality of hinge modules 254 than to a periphery portion 210a that is opposite to a periphery portion adjacent to the second housing part 220, among peripheries of the first housing part 210. For example, the conductive cavity portion 420 may be disposed between the first battery 441 disposed in the first housing part 210 and the plurality of hinge modules 254. When the conductive cavity portion 420 is adjacent to the periphery portion 211a, interference may be caused between a conductive portion formed in the periphery portion 211a and used as an antenna radiator, and the conductive cavity portion 420. The interference may cause degradation of communication performance by causing distortion of a signal transmitted and/or received through the conductive portion and a signal transmitted and/or received through the conductive cavity portion 420. When the conductive cavity portion 420 is adjacent to the periphery portion 211a, space for disposing the FPCB 430 extending from the first PCB 261 to the conductive cavity portion 420 may be insufficient. To address such problems, the conductive cavity portion 420 may be formed to be adjacent to the plurality of hinge modules 254.

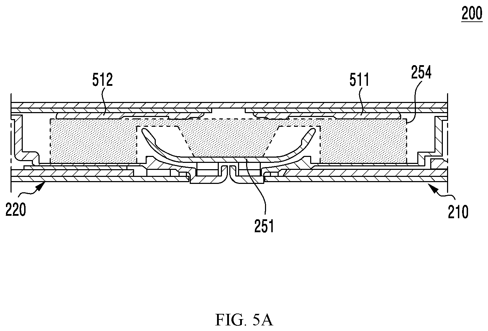

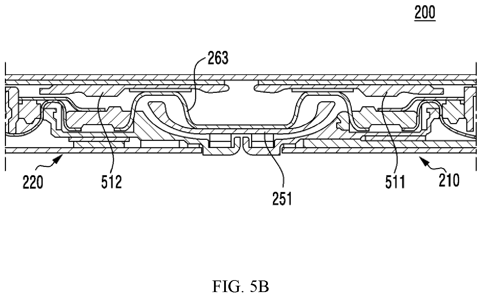

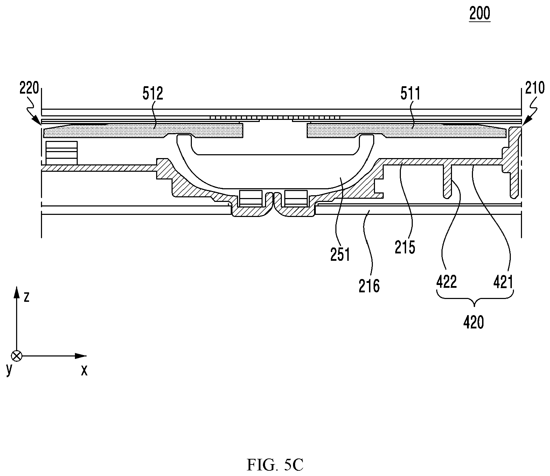

FIG. 5A is a cross-sectional view of an electronic device according to an example embodiment, cut along line A-A' of FIG. 4A. FIG. 5B is a cross-sectional view of an electronic device according to an example embodiment, cut along line B-B' of FIG. 4A. FIG. 5C is a cross-sectional view of an electronic device according to an example embodiment, cut along line C-C' of FIG. 4A.

The cross-sectional view illustrated in FIG. 5A may be referred to as a cross-sectional view of an area in which a plurality of hinge modules 254 are positioned. Referring to FIG. 5A, since components of the plurality of hinge modules 254 are disposed in the area in which the plurality of hinge modules 254 are positioned, space in which a conductive cavity portion (e.g., a conductive cavity portion 420 of FIG. 5C) may be formed may be insufficient. For example, each of the plurality of hinge modules 254 may include a first rotating plate 511, a second rotating plate 512, and gears. The rotating plates 511 and 512 may be rotatable based on a rotational operation of the gears. Due to space occupied by the rotating plates 511 and 512 and the gears, the conductive cavity portion 420 may be spaced apart from the area in which the plurality of hinge modules 254 are positioned.

The cross-sectional view illustrated in FIG. 5B may be referred to as a cross-sectional view of an area between a first hinge module 411 and a third hinge module 413. As described above, a portion of a flexible printed circuit board (FPCB) 263 may be disposed between the first hinge module (e.g., the first hinge module 411 of FIG. 4A) and the third hinge module (e.g., the third hinge module 413 of FIG. 4A). For example, when a first printed circuit board (PCB) (e.g., the first PCB 261 of FIG. 4B) and a second printed circuit board (PCB) (e.g., the second PCB 262 of FIG. 4B) are positioned close to an upper periphery portion of a foldable housing (e.g., the foldable housing 201 of FIG. 4A), the FPCB 263 extending from the first PCB 261 to the second PCB 262 may be disposed to cross a space between the first hinge module 411 and the third hinge module 413. When the FPCB 263 is positioned in the area between the first hinge module 411 and the third hinge module 413, space for forming a conductive cavity portion 420 may be insufficient. The conductive cavity portion 420 may be spaced apart from the area between the first hinge module 411 and the third hinge module 413.

The cross-sectional view illustrated in FIG. 5C may be referred to as a cross-sectional view of an area between a first hinge module (e.g., the first hinge module 411 of FIG. 4A) and a second hinge module (e.g., the second hinge module 412 of FIG. 4A). For example, when an electronic component is not mounted between the first hinge module 411 and the second hinge module 412, space for forming a conductive cavity portion 420 may be secured. For example, the conductive cavity portion 420 may be formed by removing a portion of a first bracket 215. As described above, the foldable electronic device 200 may include a rear cover 216 forming a rear exterior surface of a first housing part 210. In an embodiment, the conductive cavity portion 420 may be formed by recessing a partial area of the first bracket 215 in a direction (e.g., a +z direction) toward a flexible display 230. The conductive cavity portion 420 may include a bottom wall portion 421 and a side wall portion 422. The side wall portion 422 may extend from the bottom wall portion 421. When the conductive cavity portion 420 is covered with a second portion (e.g., the second portion 432 of FIG. 4B) of a flexible printed circuit board (FPCB) (e.g., the FPCB 430 of FIG. 4B) and RF signals are provided in the conductive cavity portion 420, the RF signals may be reflected in the conductive cavity portion 420 and radiated in a direction (e.g., a -z direction) toward the rear cover 216.

FIG. 6 illustrates a first bracket of a foldable electronic device according to an example embodiment.

Referring to FIG. 6, a first bracket 215 may include a conductive cavity portion 420. The conductive cavity portion 420 may include a bottom wall portion 421 and a side wall portion 422. A space defined by the conductive cavity portion 420 may be covered by a second portion 432 of a flexible printed circuit board (FPCB) 430.

According to an example embodiment, the FPCB 430 may include a first portion 431 and a second portion 432. For example, the first portion 431 may include a connector 431a coupled to a first printed circuit board (PCB) (e.g., the first PCB 261 of FIG. 4B). The connector 431a may provide an electrical connection between the first PCB 261 and the second portion 432 by being connected to the first PCB 261. For example, the first portion 431 and the second portion 432 may be integrally formed.

According to an example embodiment, the conductive cavity portion 420 may be formed by recessing a portion of the first bracket 215. The conductive cavity portion 420 may be covered by the second portion 432 of the FPCB 430. In terms of being a space formed in a portion of the first bracket 215, the conductive cavity portion 420 may be referred to as a groove portion, a recess portion, or a dented portion. The conductive cavity portion 420 may include the bottom wall portion 421 and the side wall portion 422 extending from the bottom wall portion 421. A space defined by the bottom wall portion 421 and the side wall portion 422 may form a cavity. An upper side (e.g., in a -z direction) of the conductive cavity portion 420 may be open.

For example, a width W of the bottom wall portion 421 parallel to an x-axis may be approximately 6 mm to 7 mm. A length L of the bottom wall portion 421 parallel to a y-axis may be approximately 26 mm to 27 mm. A height H of the side wall portion 422 parallel to a z-axis may be approximately 1.5 mm to 2.5 mm. However, the above-described numerical ranges are merely examples, and a size of the conductive cavity portion 420 is not limited to the above-described numerical ranges. The size and shape of the conductive cavity portion 420 may determine a resonant frequency of RF signals to be radiated through the conductive cavity portion 420.

According to an example embodiment, one end portion of the first portion 431 may be the connector 431a connected to the PCB. Another end portion of the first portion 431 opposite to the one end portion may be connected to the second portion 432. The second portion 432 may have a shape corresponding to a shape of the conductive cavity portion 420 so as to cover the conductive cavity portion 420. The second portion 432 may cross over the conductive cavity portion 420 (e.g., in the -z direction) and may be disposed on the side wall portion 422. The second portion 432 may be coupled to the side wall portion 422 and secured to cover the conductive cavity portion 420.

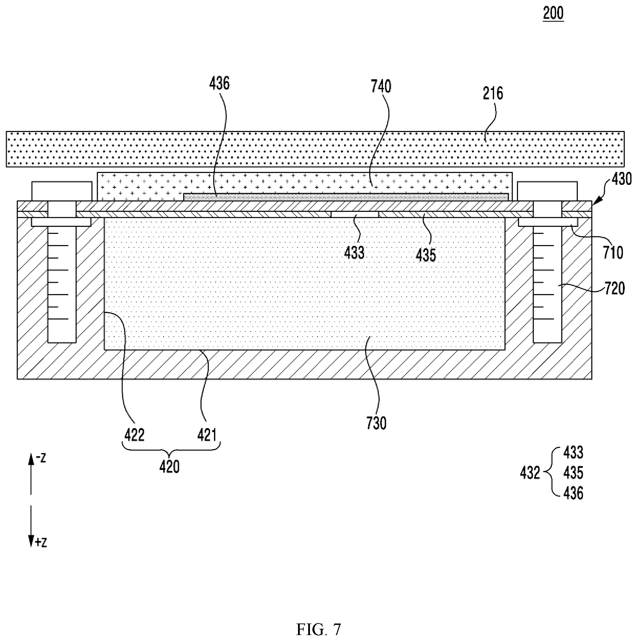

According to an example embodiment, wireless communication circuitry (e.g., the wireless communication circuitry 320 of FIG. 3) disposed on the first PCB 261 may be configured to provide RF signals to the FPCB 430 in order to transmit the RF signals. The RF signals provided from the wireless communication circuitry 320 may be provided to the first portion 431 through the first PCB 261 and the connector 431a. The RF signals may be provided to the second portion 432 through the first portion 431. The second portion 432 may include a slot (e.g., a slot 433 of FIG. 7) for radiating the RF signals using the conductive cavity portion 420. For example, the conductive cavity portion 420 may provide an effective height of an antenna (e.g., a cavity-backed slot antenna) for increasing radiation efficiency. The RF signals radiated through the slot 433 may resonate within the conductive cavity portion 420. In an embodiment, the conductive cavity portion 420 may be formed to have a volume for impedance matching of the antenna. The RF signals radiated through the slot 433 may be radiated in a direction (e.g., the -z direction) toward which the bottom wall portion 421 faces.

According to an example embodiment, the bottom wall portion 421 of the conductive cavity portion 420 may face a first direction (e.g., in the -z direction) toward a rear exterior surface of a foldable electronic device 200. Since the bottom wall portion 421 faces the first direction, the RF signals resonating within the conductive cavity portion 420 may be radiated in the first direction. According to an example embodiment, the conductive cavity portion 420 and the FPCB 430 may be configured to operate as a cavity-backed slot antenna. A main lobe of a radiation pattern formed by the cavity-backed slot antenna may be formed substantially in the first direction. Since a flexible display (e.g., the flexible display 230 of FIG. 2A) is positioned on a front exterior surface of the foldable electronic device 200, when a radiation direction of the RF signals is formed in a second direction (e.g., in a +z direction) toward the front exterior surface of the foldable electronic device 200, the RF signals may be distorted by a conductive material included in the flexible display 230, and radiation efficiency may be reduced. Since the bottom wall portion 421 faces the first direction opposite to the second direction, the RF signals may be radiated substantially in the first direction. As the RF signals are radiated in the first direction, distortion or reduction in radiation efficiency caused by the flexible display 230 may be improved.

According to an example embodiment, the second portion 432 may be coupled to the side wall portion 422 so that the second portion 432 covers at least a portion of the conductive cavity portion 420. As illustrated in FIG. 6, in an embodiment, a screw 720 may be used to secure the second portion 432 to the side wall portion 422 of the conductive cavity portion 420. To secure the second portion 432 to the first bracket 215, the screw 720 may pass through the second portion 432 and be inserted into the side wall portion 422. For example, the conductive cavity portion 420 may include a coupling portion 420a capable of supporting the second portion 432 by contacting the second portion 432. The screw 720 may be inserted into the coupling portion 420a. There may be a plurality of screws 720 and coupling portions 420a.

According to an example embodiment, a space (or cavity) defined by the conductive cavity portion 420 may be filled with a dielectric (e.g., a dielectric 730 of FIG. 7) having a dielectric constant. In an embodiment, the dielectric 730 filled in the conductive cavity portion 420 may be used to improve performance of the cavity-backed slot antenna. By filling the space defined by the conductive cavity portion 420, the dielectric 730 may affect electromagnetic characteristics of RF signals radiated through the cavity space. For example, a dielectric constant of the dielectric 730 may affect a resonant frequency of the RF signals and a gain of the cavity-backed slot antenna. As a dielectric loss of the dielectric 730 decreases, efficiency of the cavity-backed slot antenna may increase. Based on a resonant frequency of an RF signal to be radiated through the cavity-backed slot antenna, the dielectric 730 filled in the space defined by the conductive cavity portion 420 may be determined. For example, the dielectric 730 may include at least one of air, polycarbonate (PC), Teflon, polyimide (PI), or ceramic, but is not limited thereto.

FIG. 7 is a cross-sectional view of an electronic device according to an example embodiment, cut along line D-D' of FIG. 4B.

Referring to FIG. 7, a second portion 432 of a flexible printed circuit board (FPCB) 430 and a conductive cavity portion 420 may be configured to operate as a cavity-backed slot antenna. The FPCB 430 may include a plurality of layers. For example, a first portion (e.g., a first portion 431 of FIG. 8A) may include a first layer (e.g., a first layer 434 of FIG. 8A) for providing RF signals provided from wireless communication circuitry (e.g., the wireless communication circuitry 320 of FIG. 3). The first layer 434 may be referred to as a transmission layer configured to provide a path of the RF signals.

According to an example embodiment, the second portion 432 may include a second layer 435 and a third layer 436. The second layer 435 may include a slot 433. The third layer 436 may be electrically connected to the first layer 434 and may be configured such that the RF signals provided through the first layer 434 are radiated through the slot 433. As illustrated in FIG. 7, the second layer 435 including the slot 433 may be disposed to face a bottom wall portion 421 of the conductive cavity portion 420, and the third layer 436 may be disposed opposite to the second layer 435, but is not limited thereto. For example, the third layer 436 may be disposed to face the bottom wall portion 421 of the conductive cavity portion 420, and the second layer 435 including the slot 433 may be disposed opposite to the third layer 436.

According to an example embodiment, the FPCB 430 may be in contact with a washer 710. The washer 710, which is a component in the form of a thin plate used together with a screw 720, may include a conductive material (e.g., metal). According to an example embodiment, the washer 710 may be disposed between the FPCB 430 and a side wall portion 422 of the conductive cavity portion 420. The FPCB 430 may be grounded to a first bracket (e.g., the first bracket 215 of FIG. 6) by being electrically connected to the side wall portion 422 through the washer 710. According to an example embodiment, the washer 710 may be in contact with each of the second portion 432 of the FPCB 430 and the first bracket 215 to ground the FPCB 430 to the first bracket 215. A ground layer included in the second portion 432 of the FPCB 430 may be grounded to the first bracket 215 by being electrically connected to the side wall portion 422 through the washer 710. In addition to the electrical connection, the washer 710 may reduce damage to the first bracket 215 caused by the insertion of the screw 720 by distributing a load of the screw 720. The number of washers 710 may correspond to the number of screws 720. If the second portion 432 covering the conductive cavity portion 420 is not grounded, RF signals resonating within the conductive cavity portion 420 may leak, thereby acting as noise on electronic components mounted in a first housing part (e.g., the first housing part 210 of FIG. 4B). As the ground layer of the FPCB 430 is grounded through the washer 710, the RF signals resonating within the conductive cavity portion 420 may be shielded without leaking.

According to an example embodiment, a space defined by the side wall portion 422 and the bottom wall portion 421 of the conductive cavity portion 420 may be filled with a dielectric 730. As described above, the dielectric 730 may be formed from a material having a dielectric constant for adjusting electromagnetic characteristics of the RF signals.

According to an example embodiment, the bottom wall portion 421 may face a first direction (e.g., a -z direction) toward a rear exterior surface of a foldable electronic device 200. For example, the bottom wall portion 421 may face a rear cover 216 defining a rear exterior surface of the first housing part 210. A sponge 740 for mitigating impact may be interposed between the rear cover 216 and the first bracket 215. Since the bottom wall portion 421 faces the rear cover 216, the RF signals provided through the slot 433 may resonate within the conductive cavity portion 420 and may be radiated in the first direction in which the bottom wall faces.

FIG. 8A illustrates a top view of a flexible printed circuit board according to an example embodiment. FIG. 8B illustrates a bottom view of a flexible printed circuit board according to an example embodiment. FIG. 8C is a cross-sectional view of an example flexible printed circuit board.

Referring to FIG. 8A and FIG. 8B, a second portion 432 may be connected to a first portion 431. The first portion 431 may include a connector 431a connected to a first printed circuit board (PCB) (e.g., the first PCB 261 of FIG. 4B). RF signals provided from wireless communication circuitry (e.g., the wireless communication circuitry 320 of FIG. 3) disposed on the first PCB 261 may be provided to the first portion 431 through the first PCB 261 and the connector 431a. The RF signals may be transmitted along a first layer 434 included in the first portion 431.

According to an example embodiment, the second portion 432 may include a third layer 436 for receiving the RF signals provided through the first portion 431. For example, the third layer 436 may include a micro strip formed of a conductive pattern formed on a substrate, but is not limited thereto. The RF signals transmitted through the first layer 434 included in the first portion 431 may be transmitted to a feed line 436a included in the third layer 436.

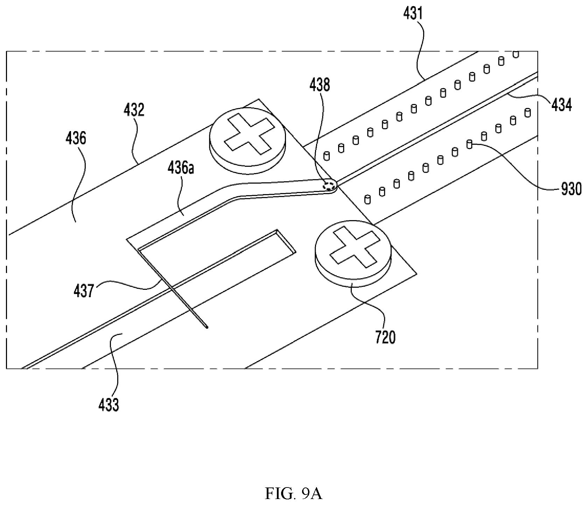

Referring to FIG. 8B, the RF signals transmitted to the feed line 436a of the third layer 436 may be coupling-fed to a slot 433 of a second layer 435 through a conductive stub (e.g., a conductive stub 437 of FIG. 9A) of the third layer 436. The RF signals fed to the slot 433 may be radiated through the slot 433. The RF signals may resonate in a space defined by a conductive cavity portion (e.g., the conductive cavity portion 420 of FIG. 7). The RF signals may be radiated to the outside of a foldable electronic device 200 by resonating based on a dielectric constant of a dielectric (e.g., the dielectric 730 of FIG. 7) filled in the space.

As illustrated in FIG. 8A and FIG. 8B, the third layer 436 may be disposed above the second layer 435, but is not limited thereto. For example, the second layer 435 including the slot 433 may be disposed above the third layer 436.

According to an example embodiment, a washer 710 may be in contact with the second portion 432. For example, the washer 710 may be in contact with the second layer 435 of the second portion 432. When the second layer 435 and the third layer 436 are disposed in reverse, the washer 710 may be in contact with the third layer 436. As described above, the second portion 432 may be electrically connected to a side wall portion (e.g., the side wall portion 422 of FIG. 7) of the conductive cavity portion 420 through the washer 710. A screw (e.g., the screw 720 of FIG. 7) may be inserted into the third layer 436 and pass through the washer 710. The screw 720 may be inserted into the side wall portion 422 passing through the third layer 436 and the washer 710. The second portion 432 may be secured to the side wall portion 422 through the screw 720.

Referring to FIG. 8C, the first portion 431 may include the first layer 434 used as a path of RF signals. The first layer 434 may be electrically connected to the connector 431a. For example, the first layer 434 may be electrically connected to the connector 431a through a conductive via 439. The RF signals provided through the connector 431a may be transmitted along the first layer 434. The first layer 434 may be electrically connected to the third layer 436 through a conductive via 438. The RF signals transmitted from the wireless communication circuitry (e.g., the wireless communication circuitry 320 of FIG. 3) through the first layer 434 may be provided to the feed line 436a of the third layer 436 of the second portion 432 through the conductive via 438. The RF signals provided to the feed line 436a of the third layer 436 may be coupling-fed to the slot 433 through the conductive stub (e.g., the conductive stub 437 of FIG. 9A) and may resonate in a space defined by the conductive cavity portion 420. The RF signals may be radiated to the outside by resonating based on a dielectric constant of the dielectric 730 filled in the space.

As described above, the FPCB 430 may include a plurality of laminated layers. The plurality of layers may include the first layer 434, the second layer 435, and the third layer 436. The first layer 434 may be disposed between the second layer 435 and the third layer 436. Since the first layer 434 is used as a transmission layer of the RF signals provided from the wireless communication circuitry 320, when the first layer 434 is disposed at an outermost portion of the FPCB 430, interference may be caused with electronic components disposed in a first housing part (e.g., the first housing part 210 of FIG. 4A). As the first layer 434 is formed as a layer disposed inside the FPCB 430, interference between the electronic components and the RF signals may be reduced, thereby reducing noise. The structure of the FPCB 430 illustrated in FIG. 8C is merely an example, and the embodiment is not limited thereto. For example, the first layer 434 used as the transmission layer of the RF signals may be formed at the outermost portion of the FPCB 430.

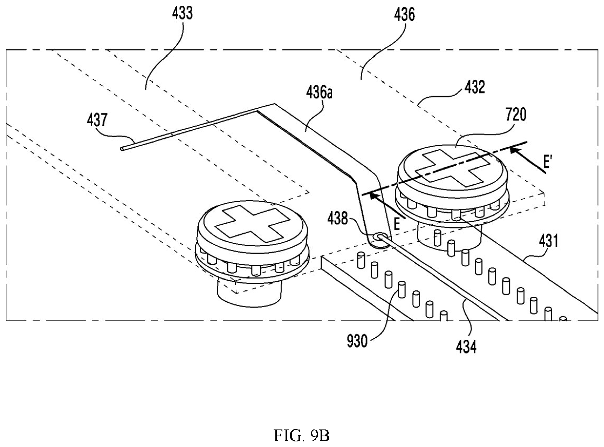

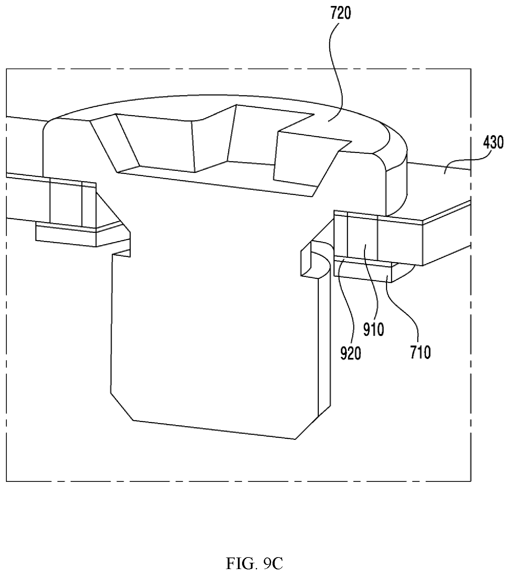

FIG. 9A illustrates a portion of a flexible printed circuit board according to an example embodiment. FIG. 9B is a perspective view of a portion of a flexible printed circuit board according to an example embodiment. FIG. 9C is a cross-sectional view of a flexible printed circuit board according to an example embodiment, cut along line E-E' of FIG. 9B.

Referring to FIG. 9A, RF signals transmitted through a first layer 434 in a first portion 431 may be provided to a third layer 436 in a second portion 432. The third layer 436 may include a feed line 436a electrically connected to the first layer 434 through a conductive via 438, and a conductive stub 437 extending from the feed line 436a to cross a slot 433. The feed line 436a may be referred to as a micro strip.

Referring to FIG. 9A, the first portion 431 may include via walls 930. The via walls 930 may protect the first layer 434 that provides a transmission path of the RF signals. The via walls 930 may block noise and reduce distortion of the RF signals by reducing electromagnetic interference with respect to the RF signals transmitted along the first layer 434. The via walls 930 may be arranged in one or more rows along the first layer 434. The via walls 930 may be referred to as a via fence or a picket fence.

According to an example embodiment, the conductive stub 437 may be referred to as a short transmission line used for matching impedance of RF signals. The conductive stub 437 may be used for coupling feed for impedance matching of the RF signals coupling-fed to the slot 433. A relative position of the conductive stub 437 with respect to the slot 433 and a length of the conductive stub 437 may determine a magnitude and a phase of impedance reflection. The conductive stub 437 may be designed such that an impedance for coupling feed is set by combining an impedance reflected by the conductive stub 437 with an impedance of the RF signals. The conductive stub 437 may reduce a voltage standing wave ratio (VSWR) of a cavity-backed slot antenna and may improve efficiency of the cavity-backed slot antenna by matching the impedance of the RF signals provided to the cavity-backed slot antenna.

Referring to FIG. 9B, the feed line 436a of the third layer 436 may be electrically connected to the first layer 434. The RF signals transmitted through the first layer 434 may be provided to the feed line 436a of the third layer 436 through the conductive via 438. The RF signals may be provided to the conductive stub 437 along the feed line 436a. A portion of the conductive stub 437 may extend over a space defined by a conductive cavity portion 420, across the slot 433. The RF signals may be coupling-fed to the slot 433 through the conductive stub 437.

Referring to FIG. 9C, a structure for grounding described above is illustrated. Referring to FIG. 9C, a screw 720 may pass through a flexible printed circuit board (FPCB) 430 and a washer 710. The washer 710 may be in contact with a ground via 910 of the FPCB 430. The washer 710 may be in contact with each of a side wall portion (e.g., the side wall portion 422 of FIG. 7) and the FPCB 430. The FPCB 430 may be grounded, through the washer 710, to a first bracket (e.g., the first bracket 215 of FIG. 6) providing a ground of a foldable electronic device 200. The washer 710 may include a conductive material to ground the FPCB 430. To reduce damage caused by contact between the FPCB 430 and the washer 710, a ring pad 920 may be disposed between the FPCB 430 and the washer 710.

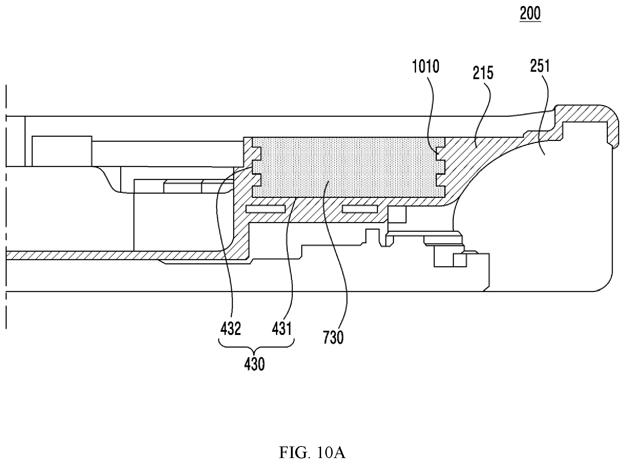

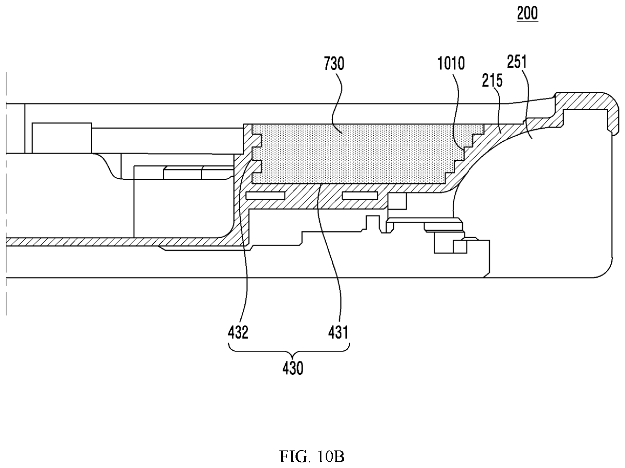

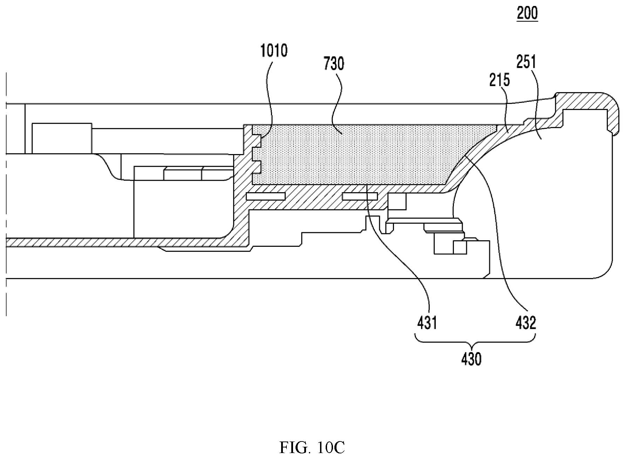

FIG. 10A, FIG. 10B, and FIG. 10C are example cross-sectional views of a conductive cavity portion of a foldable electronic device according to an example embodiment.

According to an example embodiment, a space defined by a conductive cavity portion 420 may be filled with a dielectric 730. The dielectric 730 may include air, but may also include a physically formed polymer such as polycarbonate (PC). Referring to FIG. 10A, when the space is filled with the dielectric 730 such as PC, a side wall portion 422 may include a protruding portion 1010 protruding toward the space to secure the dielectric 730. The side wall portion 422 in which the protruding portion 1010 is formed may be referred to as a convex and concave portion or a stepped portion.

According to an example embodiment, the protruding portion 1010 may protrude into the space defined by the conductive cavity portion 420. When the dielectric 730 is filled in the space, a contact extent between the dielectric 730 and the side wall portion 422 may be increased by the protruding portion 1010. As the contact extent between the dielectric 730 and the side wall portion 422 increases, the dielectric 730 may be more firmly supported by the side wall portion 422.

Referring to FIG. 10B, a first bracket 215 may be adjacent to a hinge cover 251. The hinge cover 251 may have a curved exterior surface so as not to interfere with a rotational operation of the first bracket 215. A shape of at least a portion of a side wall portion 422 may be formed to correspond to a shape of the exterior surface of the hinge cover 251. A size of a conductive cavity portion 420 may be expanded to adjust a resonant frequency of an RF signal to be transmitted and/or received through a cavity-backed slot antenna formed by the conductive cavity portion 420 and a flexible printed circuit board (FPCB) (e.g., the FPCB 430 of FIG. 6). In order to expand the size of the conductive cavity portion 420, a portion of the conductive cavity portion 420 may be extended toward the hinge cover 251. In this case, the shape of at least a portion of the side wall portion 422 may be formed to correspond to the curved exterior surface of the hinge cover 251 so that at least a portion of the side wall portion 422 corresponds to the exterior surface of the hinge cover 251. When the side wall portion 422 extending toward the hinge cover 251 includes the protruding portion 1010, the protruding portion 1010 may be formed in a stepped shape along the curved exterior surface.

Referring to FIG. 10C, unlike the protruding portion 1010 of the conductive cavity portion 420 of FIG. 10B, a protruding portion 1010 may be omitted from a side wall portion 422 extending toward a hinge cover 251. In this case, the protruding portion 1010 may be formed on a portion of the side wall portion 422 that does not overlap the hinge cover 251, and the protruding portion 1010 may be omitted from another portion of the side wall portion 422 that overlaps the hinge cover 251.

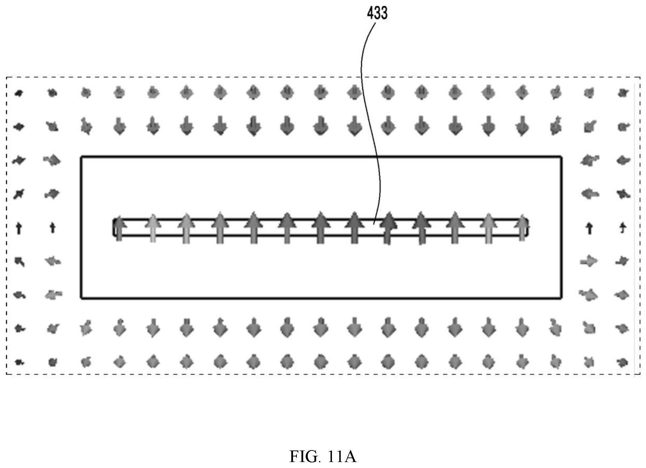

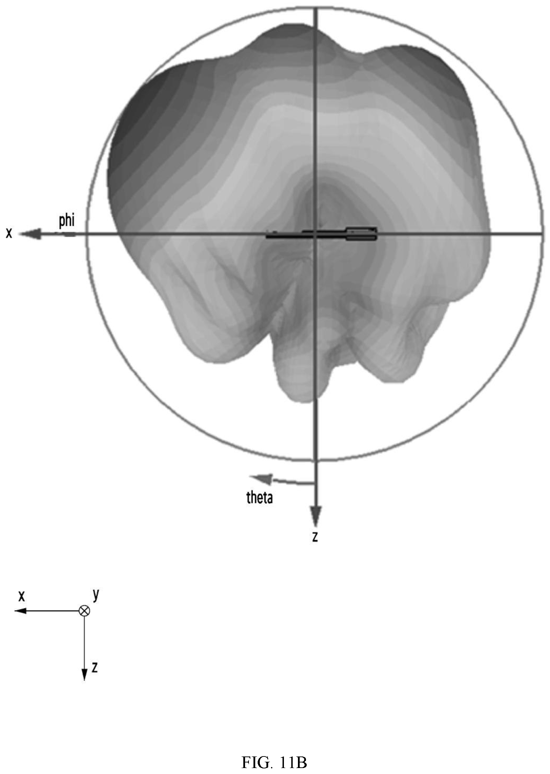

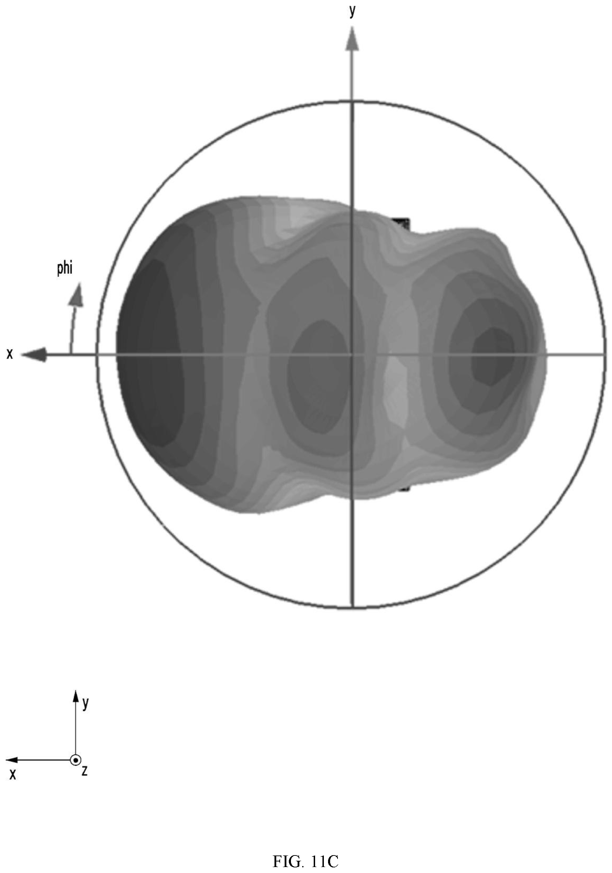

FIG. 11A illustrates a slot of a flexible printed circuit board according to an example embodiment. FIG. 11B and FIG. 11C illustrate radiation patterns formed by a cavity-backed slot antenna of an electronic device according to an example embodiment.

FIG. 11A illustrates current formed around a slot 433. Referring to FIG. 11A, when RF signals provided from wireless communication circuitry (e.g., the wireless communication circuitry 320 of FIG. 3) are excited into the slot 433, a potential difference may be formed in the slot 433. A flow of current due to the potential difference may be formed. The current may be concentrated at a center portion with respect to a longitudinal direction of the slot 433. Based on the flow of the current, an electromagnetic field may be generated. The electromagnetic field may be formed strongest at the center portion where the current is concentrated. The RF signals may be fed to the slot 433 and may be radiated to the outside through the slot 33.

FIG. 11B and FIG. 11C illustrate radiation patterns indicating a spatial distribution of electromagnetic waves radiated from a cavity-backed slot antenna. RF signals may be radiated in a direction in which a main lobe of a radiation pattern is formed. A radiation pattern illustrated in FIG. 11B illustrates a radiation pattern with respect to an azimuth angle in a state in which a foldable electronic device (e.g., the foldable electronic device 200 of FIG. 2A) is disposed such that a direction toward which a flexible display (e.g., the flexible display 230 of FIG. 2A) faces corresponds to a +z direction. A -z direction corresponds to a direction toward which a rear cover (e.g., the rear cover 216 of FIG. 2C) faces. Referring to FIG. 11B, the radiation pattern formed by the cavity-backed slot antenna may have a main lobe formed substantially in the -z direction toward which the rear cover 216 faces. A radiation pattern illustrated in FIG. 11C illustrates a radiation pattern with respect to an elevation angle in a state in which the foldable electronic device 200 is disposed such that a direction toward which the flexible display 230 faces corresponds to the -z direction. A +y direction corresponds to a direction toward which an upper periphery portion of the foldable electronic device 200 faces, and a -y direction corresponds to a direction toward which a lower periphery portion of the foldable electronic device 200 faces. Referring to FIG. 11C, the radiation pattern formed by the cavity-backed slot antenna may have a main lobe formed substantially in the -z direction toward which the rear cover 216 faces.

Since a main lobe indicates a direction in which power radiated from the cavity-backed slot antenna is concentrated, a directivity of the cavity-backed slot antenna may be substantially in the -z direction opposite to the flexible display 230. As the RF signals are radiated in the -z direction, an influence on the flexible display 230 may be reduced, and a deviation in communication performance according to a change in a state (e.g., a folded state or an unfolded state) of the foldable electronic device 200 may be small.

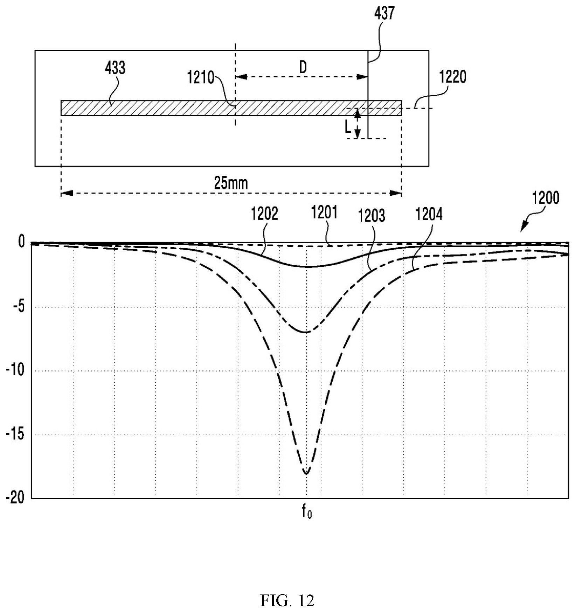

FIG. 12 is a graph illustrating a reflection coefficient of a cavity-backed slot antenna based on a length of a conductive stub of a foldable electronic device according to an example embodiment.

Referring to FIG. 12, when a length of a slot 433 is approximately 25 mm and a distance D by which a conductive stub 437 is spaced apart from a center 1210 of the length of the slot 433 is approximately 10 mm, a reflection coefficient of the cavity-backed slot antenna may be changed based on a change in a length L of the conductive stub 437 extending from a center 1220 of a width of the slot 433.

Referring to a graph 1200 of FIG. 12, the reflection coefficient of the cavity-backed slot antenna according to the change in the length L may be changed. An x-axis of the graph 1200 is frequency (unit: GHz), and a y-axis of the graph is an S-parameter (unit: dB) indicating the reflection coefficient. A reflection coefficient of RF signals may vary according to the length L of the conductive stub 437. The reflection coefficient may be referred to as a parameter indicating a degree to which power provided to a load is reflected rather than radiated. A frequency at which the reflection coefficient is the lowest may be referred to as an operating frequency (or a resonant frequency).

A first graph 1201 of FIG. 12 indicates the reflection coefficient of the cavity-backed slot antenna when the length L of the conductive stub 437 is approximately 0.75 mm. A second graph 1202 of FIG. 12 indicates the reflection coefficient of the cavity-backed slot antenna when the length L of the conductive stub 437 is approximately 1.25 mm. A third graph 1203 of FIG. 12 indicates the reflection coefficient of the cavity-backed slot antenna when the length L of the conductive stub 437 is approximately 1.75 mm. A fourth graph 1204 of FIG. 12 indicates the reflection coefficient of the cavity-backed slot antenna when the length L of the conductive stub 437 is approximately 2.25 mm.

Comparing the first graph 1201, the second graph 1202, the third graph 1203, and the fourth graph 1204, as the length L of the conductive stub 437 increases, the reflection coefficient at an operating frequency f₀ may decrease. The reflection coefficient at the operating frequency f₀ may be the smallest in the fourth graph 1204 in which the length L of the conductive stub 437 is the longest, and may be the largest in the first graph 1201 in which the length L of the conductive stub 437 is the shortest. As the reflection coefficient decreases, efficiency of the cavity-backed slot antenna increases. According to an example embodiment, as the length L of the conductive stub 437 increases, impedance matching at the operating frequency f₀ may be improved, thereby increasing the efficiency of the cavity-backed slot antenna. According to an example embodiment, the length L of the conductive stub 437 may be approximately 2.25 mm, but is not limited thereto. The length L of the conductive stub 437 may be changed according to a size and shape of a conductive cavity portion 420. For impedance matching, the length L of the conductive stub 437 may be formed to be long within an allowable range. Since a resonant frequency of the cavity-backed slot antenna may be changed when the length L is too long, the length L may be appropriately formed according to impedance matching and a resonant frequency of RF signals transmitted and/or received through the cavity-backed slot antenna.

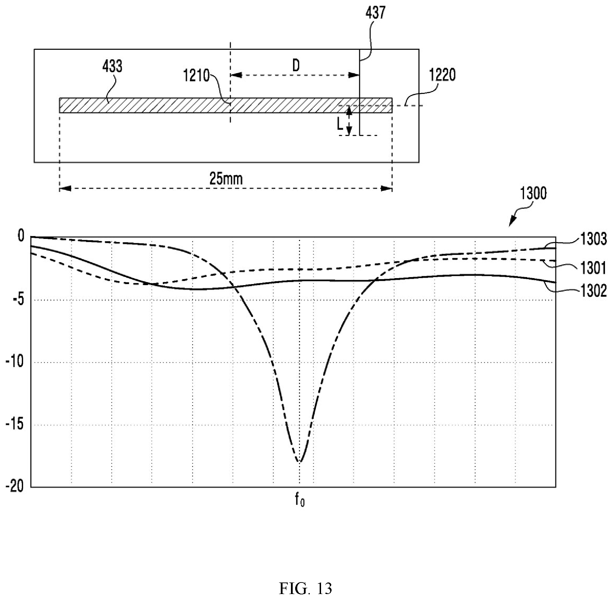

FIG. 13 is a graph illustrating a reflection coefficient of a cavity-backed slot antenna based on a position of a conductive stub of a foldable electronic device with respect to a slot according to an example embodiment.

Referring to FIG. 13, when a length of a slot 433 is approximately 25 mm and a length L by which a conductive stub 437 extends with respect to a center 1220 of a width of the slot 433 is approximately 2.25 mm, a reflection coefficient of the cavity-backed slot antenna may be changed based on a change in a distance D of the conductive stub 437 offset from a center 1210 of the length L of the slot 433.

Referring to a graph 1300 of FIG. 13, the reflection coefficient of the cavity-backed slot antenna according to the change in the distance D may be changed. An x-axis of the graph 1300 is frequency (unit: GHz), and a y-axis of the graph is an S-parameter (unit: dB) indicating the reflection coefficient. A reflection coefficient of RF signals may vary according to the distance D of the conductive stub 437. A frequency at which the reflection coefficient is the lowest may be referred to as an operating frequency (or a resonant frequency).

A first graph 1301 of FIG. 13 indicates the reflection coefficient of the cavity-backed slot antenna when the distance D of the conductive stub 437 is approximately 0 mm. A case in which the distance D is approximately 0 mm may be referred to as a position of the conductive stub 437 corresponding to a center of the length L of the slot 433. A second graph 1302 of FIG. 13 indicates the reflection coefficient of the cavity-backed slot antenna when the distance D of the conductive stub 437 is approximately 5.0 mm. A third graph 1303 of FIG. 13 indicates the reflection coefficient of the cavity-backed slot antenna when the distance D of the conductive stub 437 is approximately 10.0 mm.

Comparing the first graph 1301, the second graph 1302, and the third graph 1303, as the distance D of the conductive stub 437 increases, the reflection coefficient at an operating frequency f₀ may decrease. The reflection coefficient at the operating frequency f₀ may be the smallest in the third graph 1303 in which the distance D of the conductive stub 437 is the greatest, and may be the largest in the first graph 1301 in which the distance D of the conductive stub 437 is the smallest. As the reflection coefficient decreases, efficiency of the cavity-backed slot antenna increases. According to an example embodiment, as the distance D of the conductive stub 437 increases, impedance matching at the operating frequency f₀ may be improved, thereby increasing the efficiency of the cavity-backed slot antenna. According to an example embodiment, the distance D of the conductive stub 437 may be approximately 10.0 mm, but is not limited thereto. The distance D of the conductive stub 437 may be changed according to a size and shape of a conductive cavity portion 420. For example, for impedance matching, the distance D of the conductive stub 437 may be formed to be far within an allowable range. Since a directivity of the cavity-backed slot antenna may be degraded when the distance D is too far, the distance D may be appropriately formed to reduce the reflection coefficient while substantially maintaining directivity toward a rear cover 216.

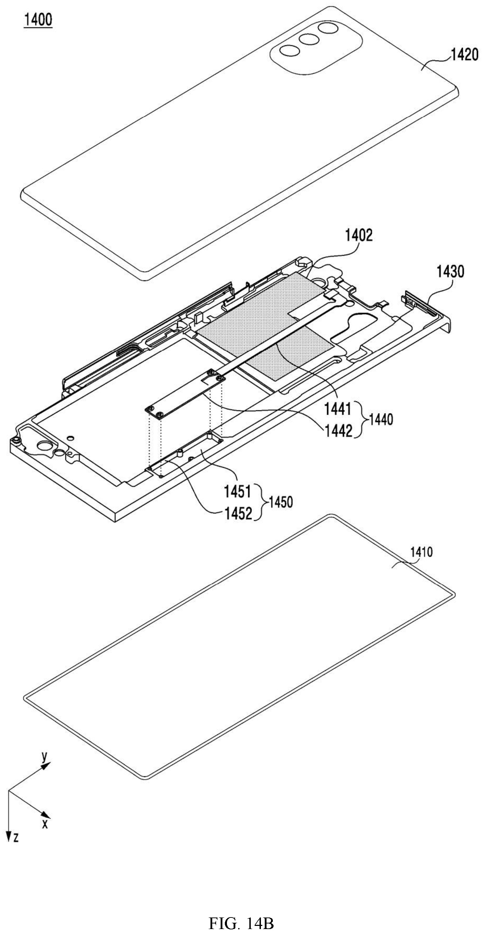

FIG. 14A illustrates an electronic device according to an example embodiment. FIG. 14B is an exploded perspective view of the electronic device illustrated in FIG. 14A.

The electronic device described above has been described as a foldable electronic device (e.g., the foldable electronic device 1400 of FIG. 2A) including a foldable housing (e.g., the foldable housing 1401 of FIG. 2A), but the embodiment of the present disclosure is not limited to the foldable electronic device 1400. Referring to FIG. 14A, an electronic device 1400 according to an example embodiment may include a bar-type housing 1401. The descriptions of the cavity-backed slot antenna described above may be applied substantially the same to the electronic device 1400 illustrated in FIG. 14A. Redundant descriptions may be omitted or briefly described. The same components may be assigned the same reference numerals.

Referring to FIG. 14A, the electronic device 1400 may include a display 1410 defining a front exterior surface of the electronic device 1400, and a rear cover 1420 defining a rear exterior surface of the electronic device 1400. The rear cover 1420 may be opposite to the display 1410. For example, the display 1410 may face a +z direction, and the rear cover 1420 may face a -z direction. The electronic device 1400 may include a housing 1401 for accommodating components of the electronic device 1400. The housing 1401 may be referred to as a bar type having a rectangular parallelepiped shape. The components of the electronic device 1400 may be accommodated in the housing 1401.

Referring to FIG. 14B, the electronic device 1400 may include a bracket 1430 disposed inside the housing 1401. The bracket 1430 may support the components of the electronic device 1400. For example, a printed circuit board (PCB) 1402 may be disposed on the bracket 1430. In addition, various components may be disposed on the bracket 1430.

The cavity-backed slot antenna described above may be formed by a flexible printed circuit board (FPCB) 1440 and a conductive cavity portion 1450 illustrated in FIG. 14B. According to an example embodiment, the bracket 1430 may include the conductive cavity portion 1450. The conductive cavity portion 1450 may include a bottom wall portion 1451 and a side wall portion 1452 extending from the bottom wall portion 1451.

The electronic device 1400 according to an example embodiment may include the PCB 1402 disposed on the bracket 1430, and wireless communication circuitry (e.g., the wireless communication circuitry 320 of FIG. 3) disposed on the PCB 1402. The wireless communication circuitry 320 may be configured to transmit RF signals to an external electronic device or receive RF signals from an external electronic device.

The electronic device 1400 according to an example embodiment may include the FPCB 1440. The FPCB 1440 (e.g., the FPCB 430 of FIG. 5B) may include a first portion 1441 (e.g., the first portion 431 of FIG. 5B) and a second portion 1442 (e.g., the second portion 432 of FIG. 5B). The second portion 1442 may be disposed to cover the conductive cavity portion 1450 (e.g., the conductive cavity portion 420 of FIG. 6). The first portion 1441 may be configured to provide a path of RF signals from the wireless communication circuitry 320 to the second portion 1442.

According to an example embodiment, the second portion 1442 of the FPCB 1440 and the conductive cavity portion 1450 may be configured to operate as a cavity-backed slot antenna. For example, the second portion 1442 may be secured on the bracket 1430 (e.g., the first bracket 215 of FIG. 6) through a screw (e.g., the screw 720 of FIG. 7). The second portion 1442 may be grounded to the bracket 1430 through a washer (e.g., the washer 710 of FIG. 7). The structure of the FPCB 430 illustrated in FIG. 8C may correspond to the structure of the FPCB 1440 illustrated in FIG. 14B. According to an example embodiment, the first portion 1441 of the FPCB 1440 may include a first layer (e.g., the first layer 434 of FIG. 8C) configured to provide RF signals from the wireless communication circuitry 320. The second portion 1442 of the FPCB 1440 may include a second layer (e.g., the second layer 435 of FIG. 8C) including a slot (e.g., the slot 433 of FIG. 8C). The FPCB 1400 may include a third layer (e.g., the third layer 436 of FIG. 8C) electrically connected to the first layer and configured to provide RF signals through the slot 433 to a space defined by the conductive cavity portion 1450. The cavity-backed slot antenna may be configured to radiate RF signals toward the rear cover 1420.

A foldable electronic device 200 is provided. The foldable electronic device 200 may comprise a foldable housing 201. The foldable housing 201 may include a first housing part 210 and a second housing part 220 rotatably coupled to the first housing part 210 through a plurality of hinge modules 254 including a first hinge module 411 and a second hinge module 412. The foldable electronic device 200 may comprise a printed circuit board (PCB) 261 disposed in the first housing part 210. The foldable electronic device 200 may comprise wireless communication circuitry 320 on the PCB 261. The foldable electronic device 200 may comprise a bracket 215 disposed in the first housing part 210. The bracket 215 may include a conductive cavity portion 420, and the conductive cavity portion 420 may include a bottom wall portion 421 and a side wall portion 422 extending from the bottom wall portion 421. The foldable electronic device 200 may comprise a flexible printed circuit board (FPCB) 430 including a first portion 431 and a second portion 432 including a slot 433. The second portion 432 may be disposed to cover the conductive cavity portion 420. The first portion 431 may be configured to provide a path of radio frequency (RF) signals from the wireless communication circuitry 320 to the second portion 432. The second portion 432 of the FPCB 430 and the conductive cavity portion 420 may be configured to operate as a cavity-backed slot antenna. At least a portion of the cavity-backed slot antenna may be disposed between the first hinge module 411 and the second hinge module 412. According to the present disclosure, an antenna may be added in the first housing part 210 by implementing a cavity-backed slot antenna using the conductive cavity portion 420 of the bracket 215 and the second portion 432 of the FPCB 430.

According to an example embodiment, the first portion 431 of the FPCB 430 may include a first layer 434 configured to provide the RF signals provided from the wireless communication circuitry 320. The second portion 432 of the FPCB 430 may include a second layer 435 including the slot 433. The second portion 432 of the FPCB 430 may include a third layer 436 electrically connected to the first layer 434 and configured to feed the RF signals to the slot 433. According to the present disclosure, the first portion 431 may be configured to provide a path for the RF signals, and the second portion 432 may be configured to provide a radiator of the cavity-backed slot antenna.

According to an example embodiment, the first layer 434 may be disposed between the second layer 435 and the third layer 436. According to the present disclosure, the first layer 434, which transmits the RF signals, may be disposed inside the FPCB 430, thereby protecting the RF signals from noise.

According to an example embodiment, the third layer 436 may include a conductive stub 437 for impedance matching of the RF signals. The conductive stub 437 may be offset from a center of a length L of the slot 433.

According to an example embodiment, the FPCB 430 may comprise a conductive via 438 electrically connecting the first layer 434 to the third layer 436. The RF signals provided from the wireless communication circuitry 320 may be fed to the slot 433 through the first layer 434, the conductive via 438, the third layer 436, and the second layer 435, thereby being provided to the space and radiated to the outside of the foldable electronic device 200 through the space.

According to an example embodiment, the foldable electronic device 200 may further comprise a washer 710 in contact with each of the second portion 432 of the FPCB 430 and the bracket 215 to ground the FPCB 430 to the bracket 215. According to the present disclosure, the FPCB 430 may be grounded by the washer 710.

According to an example embodiment, the foldable electronic device 200 may further comprise a screw 720 inserted into the side wall portion 422 through the second portion 432 of the FPCB 430 and the washer 710 to secure the second portion 432 of the FPCB 430 to the bracket 215.

According to an example embodiment, the plurality of hinge modules 254 may include rotating plates 511 and 512 rotatably connecting the first housing part 210 to the second housing part 220. The foldable electronic device 200 may comprise a hinge cover 251 at least partially enclosing the rotating plates. The conductive cavity portion 420 may be adjacent to the plurality of hinge modules 254, in the first housing part 210.

According to an example embodiment, a shape of at least a portion of the side wall portion 422 may correspond to a shape of an exterior surface of the hinge cover 251.

According to an example embodiment, the plurality of hinge modules 254 may further comprise a third hinge module 413. The first hinge module 411 may be positioned between the second hinge module 412 and the third hinge module 413. The foldable electronic device 200 may further comprise another FPCB 263 extending from the PCB 261 in the first housing part 210, across a space between the first hinge module 411 and the third hinge module 413, to another PCB 262 in the second housing part 220.

According to an example embodiment, the plurality of hinge modules 254 may be configured to provide an folded state in which the first housing part 210 and the second housing part 220 are folded, and a unfolded state in which the first housing part 210 and the second housing part 220 are unfolded.

According to an example embodiment, the foldable electronic device 200 may further comprise a battery 441 disposed in the first housing part 210. The conductive cavity portion 420 may be positioned between the battery 441 and the plurality of hinge modules 254.

According to an example embodiment, the foldable electronic device 200 may further comprise a dielectric 730 filling a space defined by the bottom wall portion 421 and the side wall portion 422.

According to an example embodiment, the side wall portion 422 may include a protruding portion 1010 protruding toward the space to secure the dielectric 730.

According to an example embodiment, the foldable electronic device 200 may further comprise a flexible display 230 disposed in the first housing part 210 and the second housing part 220. The foldable electronic device 200 may further comprise a rear cover 216 opposite to the flexible display 230. The RF signals may be radiated toward the rear cover 216.

According to an example embodiment, the bottom wall portion 421 may face the rear cover 216.

According to an example embodiment, the width of the bottom wall portion 421 may be 6 mm to 7 mm. The length of the bottom wall portion 421 may be 26 mm to 27 mm. The height of the side wall portion 422 may be 1.5 mm to 2.5 mm.

An electronic device 1400 is provided. The electronic device 1400 may comprise a housing 1401 defining an exterior of the electronic device 1400. The electronic device 1400 may comprise a PCB 1402 disposed in the housing 1401. The electronic device 1400 may comprise wireless communication circuitry 320 disposed on the PCB 1402. The electronic device 1400 may comprise a bracket 1430 disposed in the housing 1401. The bracket 1430 may include a conductive cavity portion 1450, and the conductive cavity portion 1450 may include a bottom wall portion 421 and a side wall portion 422 extending from the bottom wall portion 421. The electronic device 1400 may comprise an FPCB 1440 including a first portion 1441 and a second portion 1442 including a slot 433. The second portion 1442 may be disposed to cover the conductive cavity portion 1450. The first portion 1441 may be configured to provide a path of radio frequency (RF) signals from the wireless communication circuitry 320 to the second portion 1442. The second portion 1442 of the FPCB 1440 and the conductive cavity portion 1450 may be configured to operate as a cavity-backed slot antenna. The cavity-backed slot antenna according to the present disclosure may be included in the electronic device 1400 including a bar-type housing 1401.

According to an example embodiment, the first portion 1441 of the FPCB 1440 may include a first layer 434 configured to provide the RF signals provided from the wireless communication circuitry 320. The second portion 1442 of the FPCB 1440 may include a second layer 435 including the slot 433. The second portion 1442 of the FPCB 1440 may include a third layer 436 electrically connected to the first layer 434 and configured to feed the RF signals to the slot 433.

According to an example embodiment, the electronic device 1400 may further comprise a washer 710 in contact with each of the second portion 1442 of the FPCB 1440 and the bracket 1430 to ground the FPCB 1440 to the bracket 1430.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A foldable electronic device comprising:
a foldable housing including:
a first housing part; and
a second housing part rotatably coupled to the first housing part through a plurality of hinge modules including a first hinge module and a second hinge module;
a printed circuit board (PCB) disposed in the first housing part;
wireless communication circuitry on the PCB;
a bracket disposed in the first housing part and including a conductive cavity portion, the conductive cavity portion including a bottom wall portion and a side wall portion extending from the bottom wall portion; and
a flexible printed circuit board (FPCB) including a first portion and a second portion including a slot, the second portion disposed to cover the conductive cavity portion, the first portion configured to provide a path of radio frequency (RF) signals from the wireless communication circuitry to the second portion,
wherein the second portion of the FPCB and the conductive cavity portion are configured to operate as a cavity-backed slot antenna, and
wherein at least a portion of the cavity-backed slot antenna is disposed between the first hinge module and the second hinge module.

2. The foldable electronic device of claim 1,
wherein the first portion of the FPCB includes a first layer configured to provide the RF signals provided from the wireless communication circuitry, and
wherein the second portion of the FPCB includes:
a second layer including the slot, and
a third layer electrically connected to the first layer and configured to feed the RF signals to the slot.

3. The foldable electronic device of claim 2,
wherein the first layer is disposed between the second layer and the third layer.

4. The foldable electronic device of claim 2 or 3,
wherein the third layer includes a conductive stub for impedance matching of the RF signals, and
wherein the conductive stub is offset from a center of a length of the slot.

5. The foldable electronic device of any one of claims 2 to 4,
wherein the FPCB comprises a conductive via electrically connecting the first layer to the third layer, and
wherein the RF signals provided from the wireless communication circuitry are fed to the slot through the first layer, the conductive via, the third layer, and the second layer, and are radiated to the outside of the foldable electronic device.

6. The foldable electronic device of any one of claims 1 to 5, further comprising a washer contacted with each of the second portion of the FPCB and the bracket to ground the FPCB to the bracket.

7. The foldable electronic device of claim 6, further comprising a screw inserted into the side wall portion through the second portion of the FPCB and the washer to secure the second portion of the FPCB to the bracket.

8. The foldable electronic device of any one of claims 1 to 7, wherein the plurality of hinge modules include rotating plates rotatably connecting the first housing part to the second housing part, and
wherein the foldable electronic device further comprises a hinge cover at least partially enclosing the rotating plates, and
wherein the conductive cavity portion is adjacent to the plurality of hinge modules, in the first housing part.

9. The foldable electronic device of claim 8,
wherein a shape of at least a portion of the side wall portion corresponds to a shape of an exterior surface of the hinge cover.

10. The foldable electronic device of any one of claims 1 to 9,
wherein the plurality of hinge modules further comprises a third hinge module,
wherein the first hinge module is positioned between the second hinge module and the third hinge module, and
wherein the foldable electronic device further comprises another FPCB extending from the PCB in the first housing part, across a space between the first hinge module and the third hinge module, to another PCB in the second housing part.

11. The foldable electronic device of claim 10,
wherein the plurality of hinge modules are configured to provide a folded state in which the first housing part and the second housing part are folded, and an unfolded state in which the first housing part and the second housing part are unfolded.

12. The foldable electronic device of any one of claims 1 to 11, further comprising a battery disposed in the first housing part,
wherein the conductive cavity portion is positioned between the battery and the plurality of hinge modules.

13. The foldable electronic device of any one of claims 1 to 12, further comprising a dielectric filling a space defined by the bottom wall portion and the side wall portion.

14. The foldable electronic device of claim 13,
wherein the side wall portion includes a protruding portion protruding toward the space to secure the dielectric.

15. The foldable electronic device of any one of claims 1 to 14, further comprising:
a flexible display disposed in the first housing part and the second housing part; and
a rear cover opposite to the flexible display,
wherein the RF signals are radiated toward the rear cover.
